# EUROPÄISCHE PATENTSCHRIFT

(11) **EP 4 046 472 B1**
(45) Veröffentlichungstag und Bekanntmachung des Hinweises auf die Patenterteilung: **20.11.2024**
(21) Anmeldenummer: 20792347.5
(22) Anmeldetag: 12.10.2020
(51) Int. Cl.: H05K 7/20, H05K 7/14

(54) **RECHENZENTRUM UND VERFAHREN**
COMPUTING CENTER AND METHOD
PROCÉDÉ ET CENTRE INFORMATIQUE

(30) Priorität: 15.10.2019 DE 102019127752
(43) Veröffentlichungstag der Anmeldung: 24.08.2022
(73) Patentinhaber: WAIYS GmbH, 01099 Dresden (DE)
(72) Erfinder: WEISEMANN, Anne, 01069 Dresden (DE); WÄCHTER, Conrad, 01099 Dresden (DE); BUDER, Ricardo, 01127 Dresden (DE); STRUCKMEIER, Jens, 01277 Dresden (DE)
(74) Vertreter: Viering, Jentschura & Partner mbB Patent- und Rechtsanwälte
(86) Internationale Anmeldenummer: PCT/EP2020/078596
(87) Internationale Veröffentlichungsnummer: WO 2021/074071

(56) Entgegenhaltungen:
- DE-A1- 102017 121 365
- JP-A- 2012 042 105

## Beschreibung

Verschiedene Ausführungsbeispiele betreffen ein Rechenzentrum und ein Verfahren.

Im Allgemeinen werden Rechenzentren verwendet, um in zentralisierter Weise eine große Rechenleistung bereitzustellen. Dabei kommen häufig tausende Prozessoren zum Einsatz. Die davon verursachte hohe Menge an Abwärme erfordert ein geeignetes Kühlungskonzept, um die Abwärme auf wirtschaftliche und ökologische Weise abzuführen. Herkömmlicherweise steht dabei nur die Effizienz des Abtransports der Wärme im Fokus.

Bezüglich verschiedener Kühlungskonzepte wird verwiesen auf die WO 2018/201 425 A1, welche ein Datenzentrum-Kühlsystem beschreibt, die US 2009 / 0 133 866 A1, welche eine hybride Luft- und Flüssigkühlmittel-Klimaeinheit beschreibt, und die US 2014 / 0069 111 A1, welche eine thermoelektrisch unterstützte Luft- und Flüssigkeitskühlung beschreibt. DE 10 2017 121 365 A1 beschreibt ein mit Luft gekühltes Container-Rechenzentrum. JP 2012 042 105 A beschreibt ein Kühlsystem mittels eines Kaltflüssigkeits-Kreislaufes, wobei eine Wärmepumpe dem Kaltflüssigkeits-Kreislauf thermische Energie entzieht und einem Heißflüssigkeits-Kreislauf zuführt.

Gemäß verschiedenen Ausführungsformen wurde erkannt, dass ein luftbasiertes und/oder hybrides (wasser-/luftbasiertes) Kühlungskonzept herkömmlicherweise nur schwer ganzjährig betreibbar ist, da dieses auf das Vorhandensein von kühler Frischluft angewiesen sind, welche nur in wenigen Klimazonen die benötigte Kühlleistung auch in den Sommermonaten erbringen kann. Zudem bringt ein direkter Luftaustausch mit der Umgebung aufgrund der benötigten Filter einen erhöhten Wartungs- und Energieaufwand mit sich. Findet ein zusätzlicher Wärmeübergang mit Systemtrennung auf einen Außenkreislauf statt, senkt sich die Temperatur des zu kühlenden Mediums weiter und erhöht damit den Anspruch auf das Vorhandensein einer Wärmesenke mit niedrigen Temperaturen.

Ist ganzjährig keine natürliche Wärmesenke vorhanden, wird herkömmlicherweise eine Kompressionskälteanlage verwendet. Bei dieser kann die Kondensation auf einem höheren Temperaturniveau stattfinden, was jedoch aufgrund des Bedarfs an einer Außeneinheit, welche die Wärme vom Kältemittel an die Außenluft abgibt, zusätzlichen Platzbedarf mit sich bringt. Des Weiteren sinkt die Leistungszahl von Kälteanlagen bei hohen Außentemperaturen, was einen erhöhten Elektroenergiebedarf mit sich bringt.

Beide herkömmlichen Varianten verwenden Luft als Wärmeträgermedium. Durch die geringe Dichte und Wärmespeicherkapazität von Luft wird die Menge an Wärme, welche mittels des Mediums transportiert werden kann, begrenzt. Eine Erhöhung des Luftvolumenstroms und ein Senken der Eintrittstemperatur sind nur zu einem gewissen Grad technisch realisierbar und wirtschaftlich sinnvoll. Deshalb ist die Leistungsdichte bei herkömmlichen Systemen auf herkömmlicherweise unter 3 kW (Kilowatt) pro Rack begrenzt oder zumindest auf deutlich weniger als 80 kW pro Rack.

Gemäß verschiedenen Ausführungsformen wird ein Rechenzentrum, beispielsweise für den Einsatz als Container-Rechenzentrum, bereitgestellt, welches eine verbesserte Infrastruktur zum Abführen thermischer Energie (auch als Kühl-Infrastruktur bezeichnet) aus dem Rechenzentrum heraus. Die Kühl-Infrastruktur ermöglicht es anschaulich, das Rechenzentrum ganzjährig und/oder selbst in heißen Klimazonen betreiben. Dementsprechend wird ein Verfahren zu Betreiben des Rechenzentrums bereitgestellt.

Anschaulich weist die Kühl-Infrastruktur zwei Wasserkreisläufe mit unterschiedlichen Temperaturniveaus auf, die mittels einer Wärmepumpe miteinander gekoppelt sind. Im Betrieb wird der Luft innerhalb des Raums mittels des niedrigeren Temperaturniveaus Wärme entzogen (d.h. diese wird gekühlt). Diese Wärme wird mittels der Wärmepumpe auf ein höheres Temperaturniveau gehoben und in das höhere Temperaturniveau eingespeist, mittels dessen die Wärme weggebracht wird. Das höhere Temperaturniveau erleichtert es, die Wärme freizusetzen oder einer wirtschaftlichen Nutzung zuzuführen.

Gemäß verschiedenen Ausführungsformen kann ein Rechenzentrum (auch als RZ bezeichnet) aufweisen: eine in einem Raum angeordnete Rechenanlage, wobei die Rechenanlage mehrere Kühlkörper und mehrere Prozessoren aufweist, von denen jeder Prozessor mit einem Kühlkörper der mehreren Kühlkörper thermisch gekoppelt ist; zumindest eine in dem Raum angeordnete Wärmepumpe; zumindest einen in dem Raum angeordneten Gas-Flüssigkeit-Wärmetauscher; einen Heißflüssigkeit-Kreislauf, welcher die mehreren Kühlkörper mit der Wärmepumpe koppelt, wobei der Heißflüssigkeit-Kreislauf ferner an einer Wand des Raums einen Heißflüssigkeit-Anschluss aufweist, wobei der Heißflüssigkeits-Kreislauf thermische Energie durch den Heißflüssigkeits-Anschluss aus dem Raum heraus bereitstellt; und einen Kaltflüssigkeit-Kreislauf, welcher die Wärmepumpe mit dem Gas-Flüssigkeit-Wärmetauscher koppelt; wobei die Wärmepumpe eingerichtet ist, dem Kaltflüssigkeit-Kreislauf thermische Energie zu entziehen und diese dem Heißflüssigkeit-Kreislauf zuzuführen.

Um kontinuierlichem Wachstum Rechnung zu tragen, können Container-Rechenzentren eingesetzt werden, bei denen die Komponenten eines RZ in einem Container angeordnet werden. Solche Container können von Herstellern ab Werk vorgefertigt und vorinstalliert werden und ermöglichen dadurch einen effizienten modularen Aufbau von größeren Rechenzentren. Gemäß verschiedenen Ausführungsformen kann der Raum als ein Container eingerichtet sein. Dann kann das RZ auch als Container-RZ bezeichnet sein. Der Effekt der Containerform ist eine größere Mobilität und Modularität des RZ.

Gemäß verschiedenen Ausführungsformen kann ein Container-Rechenzentrum (Container-RZ) Folgendes aufweisen: einen Container und eine in dem Container angeordnete Rechenanlage, wobei die Rechenanlage mehrere Kühlkörper und mehrere Prozessoren aufweist, von denen jeder Prozessor mit einem Kühlkörper der mehreren Kühlkörper thermisch gekoppelt ist; wobei der Container zumindest eine Wärmepumpe und einen Gas-Flüssigkeit-Wärmetauscher aufweist; einen Heißflüssigkeit-Kreislauf aufweist, welcher die mehreren Kühlkörper mit der Wärmepumpe koppelt, wobei der Heißflüssigkeit-Kreislauf ferner an einer Wand (z.B. Zwischenwand) des Containers einen Heißflüssigkeit-Anschluss aufweist, wobei der Heißflüssigkeits-Kreislauf thermische Energie durch den Heißflüssigkeits-Anschluss aus dem Raum heraus bereitstellt; einen Kaltflüssigkeit-Kreislauf aufweist, welcher die zumindest Wärmepumpe mit dem Luft-Flüssigkeit-Wärmetauscher koppelt; wobei die zumindest Wärmepumpe eingerichtet ist, dem Kaltflüssigkeit-Kreislauf thermische Energie zu entziehen und diese dem Heißflüssigkeit-Kreislauf zuzuführen.

Es zeigen
Figuren 1 und 9 ein RZ gemäß verschiedenen Ausführungsformen in einem schematischen Aufbaudiagram;
Figur 2 ein Verfahren gemäß verschiedenen Ausführungsformen in einem schematischen Ablaufdiagramm;
Figur 3 ein Container-RZ gemäß verschiedenen Ausführungsformen in einer schematischen Aufbaudiagram;
Figur 4 ein RZ gemäß verschiedenen Ausführungsformen in einem schematischen Versorgungsdiagram;
Figuren 5 bis 8 jeweils ein RZ gemäß verschiedenen Ausführungsformen in verschiedenen detaillierten Aufbaudiagrammen;
Figuren 10 und 11 jeweils ein Container-RZ gemäß verschiedenen Ausführungsformen in einem schematischen Perspektivansicht; und
Figuren 12 bis 14 jeweils ein Verfahren gemäß verschiedenen Ausführungsformen in einem schematischen Ablaufdiagramm.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist. Gemäß verschiedenen Ausführungsformen kann der Begriff "gekoppelt" oder "Kopplung" im Sinne einer (z.B. mechanischen, hydrostatischen, fluidleitenden, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung (z.B. Energie) übertragen werden kann. Beispielsweise können zwei miteinander gekoppelte Elemente eine Wechselwirkung miteinander austauschen, z.B. eine mechanische, hydrostatische, thermische und/oder elektrische Wechselwirkung. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Als Steuern kann eine beabsichtigte Beeinflussung eines Systems verstanden werden. Dabei kann der Zustand des Systems gemäß einer Vorgabe (auch als Soll-Zustand bezeichnet) verändert werden. Regeln kann als Steuern verstanden werden, wobei zusätzlich einer Zustandsänderung des Systems durch Störungen entgegengewirkt wird. Anschaulich kann die Steuerung eine nach vorn gerichtete Steuerstrecke aufweisen und somit anschaulich eine Ablaufsteuerung implementieren, welche eine Eingangsgröße (z.B. die Vorgabe) in eine Ausgangsgröße umsetzt. Die Steuerstrecke kann aber auch Teil eines Regelkreises sein, so dass eine Regelung implementiert wird. Die Regelung weist im Gegensatz zu der reinen Vorwärts-Steuerung eine fortlaufende Einflussnahme der Ausgangsgröße auf die Eingangsgröße auf, welche durch den Regelkreis bewirkt wird (Rückführung). Mit anderen Worten kann alternativ oder zusätzlich zu der Steuerung eine Regelung verwendet werden bzw. alternativ oder zusätzlich zu dem Steuern ein Regeln erfolgen. Bei einer Regelung wird ein Ist-Zustand der Regelgröße (z.B. basierend auf einem Messwert ermittelt) mit einem Führungswert (z.B. dem Soll-Zustand der Regelgröße) verglichen und entsprechend kann die Regelgröße mittels einer Stellgröße (unter Verwendung eines Stellglieds) derart beeinflusst werden, dass sich möglichst eine geringe Abweichung des jeweiligen Ist-Zustand der Regelgröße vom Führungswert ergibt. Der Zustand des Systems kann beispielsweise von zumindest einer physischen Größe des Systems repräsentiert werden. Das Steuern und/oder Regeln kann mittels einer Steuervorrichtung erfolgen, die beispielsweise separat von der Rechenanlage oder als Teil dieser implementiert werden kann. Die Steuervorrichtung kann eingerichtet sein, ein hierin beschriebenes Verfahren durchzuführen.

Die einem Rechenzentrum zugeführte elektrische Leistung wird im Wesentlichen zu 100% in Wärmeenergie (kurz auch als Wärme bezeichnet) umgewandelt. Der Großteil der Wärme entsteht typischerweise in den Servern durch Halbleiterbauelemente innerhalb der Server. Weitere Wärmequellen des RZ sind die elektrische Zuleitung, Wärmeverluste in den (Heißwasser-) Leitungen, sämtliche elektrische Verbraucher, aber auch Sicherungen und elektrische Bauteile im Stromkreislauf. Zu den Verbrauchern zählen auch sämtliche Regelungs- und Steuerungseinheiten, Ventile, Klappen, sowie Steuerelektronik, Beleuchtung, Netzwerktechnik, Brandschutzanlagen, USV, Batterien, Akkus (insbesondere bei Entlade- und Ladevorgängen), sowie Zugangskontrollen und sämtliche Sicherheitstechnik inkl. Einbruchsschutz.

Gemäß verschiedenen Ausführungsformen wurde erkannt, dass es wirtschaftlich nicht rentabel oder sogar technisch erschwert ist, alle der oben aufgeführten Wärmequellen flüssigkeitsgekühlt einzurichten. Dementsprechend wird deren Abwärme anderweitig abgeführt. Wird die Abwärme nicht abgeführt, steigt die Temperatur innerhalb eines hermetisch abgeschlossenen Raums kontinuierlich bis weit über die erlaubten Betriebsgrenzen hinaus. Um dem entgegenzuwirken, kann das RZ eine Wasser/Wasser-Kältemaschine aufweisen, die zur Kühlung der in der Luft gebundenen Wärme einen warmen Wasser-Kreislauf speist. Die Wasser/Wasser-Kältemaschine wird dabei als Wärmepumpe betrieben, das heißt, dass die Wärme durch den Kondensator der Kältemaschine in den warmen Wasser-Kreislauf eingespeist wird. Das führt dazu, dass der hohe Platzbedarf für eine Außeneinheit wegfällt und zudem die Nachnutzung der Abwärme ermöglicht wird. Die Wärmesenke kann beispielsweise ganzjährig auf einem konstanten Temperaturniveau gehalten werden, was es ermöglicht, die Kältemaschine samt deren Kältemittel derart auszuwählen, dass eine hohe Effizienz in diesem Arbeitspunkt erreicht werden kann.

Gemäß verschiedenen Ausführungsformen kann ein Sekundärluftsystem bereitgestellt sein, welches einen oder mehr als einen Ventilator aufweist. Das Sekundärluftsystem kann eingerichtet sein Luft aus dem Raum anzusaugen und wieder in den Raum abzugeben, beispielsweise ohne die Luft aus dem Raum herauszuführen oder gegen andere Luft auszutauschen, so dass anschaulich ein in sich geschlossener Luftstrom innerhalb des Raums bereitgestellt wird. Pro Ventilator kann beispielsweise eine Luftleistung bereitgestellt werden im Bereich von 1000 bis 11000 m³/h (Kubikmeter pro Stunde) bei einer Pressung von 50 bis 200 Pa (Pascal), beispielsweise eine Luftleistung im Bereich von 9000 bis 11000 m³/h bei einer Pressung von 75 bis 175 Pa, oder beispielsweise eine Luftleistung im Bereich von 9800 bis 10200 m³/h bei einer Pressung von 100 bis 150 Pa. Ein Ventilator, der in diesem Bereich arbeitet hat sich als besonders energieeffizient herausgestellt. Beispielsweise kann der Ventilator eine Luftleistung von 10000 m³/h bei einer Pressung von 100 bis 150 Pa haben.

Die Rechenanlage des oder jedes Raums weist eine oder mehr als eine Recheneinheit (z.B. eine Reihe aus Racks) auf, die beispielsweise zum hochdichten Aufnehmen von einer Vielzahl von Prozessoren und/oder Speichermedien eingerichtet ist. Dabei können Prozessoren beispielsweise Serverprozessoren (CPUs), Grafikkartenprozessoren (GPUs), Kryptoprozessoren, ASICs, FPGA's, TPU (tensor processing unit), oder Mining Hardware für Kryptowährungen sein. Speichermedien können mechanische Festplatten (HDDs) oder Halbleiter-Speicher (SSDs) sein.

Die Rechenanlage kann mehrere Gestelle (z.B. Prozessorracks und/oder Regale aufweisend) zum hochdichten Aufnehmen von einer Vielzahl von Prozessoren aufweisen. Mit anderen Worten ermöglicht das RZ eine besonders effiziente Anordnung von Prozessoren, die einerseits eine hohe Dichte der Prozessoren ermöglicht, aber andererseits auch eine ausreichende Kühlung der Prozessoren sicherstellt. In verschiedenen Ausführungsformen sind die Prozessoren auf entsprechenden Prozessorkarten, z.B. auf elektronischen Platinen mit für den Prozessor notwendiger Elektronik angeordnet, die mittels der Gestelle gehalten werden. Prozessorkarten können beispielsweise Grafikarten sein. Die hochdichte Anordnung entspricht einer Anordnung, die es erlaubt, dass in verschiedenen Ausführungsformen in einem ersten Gestell und einem zweiten Gestell in jeweils mindestens einer Reihe beispielsweise mindestens 8, beispielsweise mindestens 10, beispielsweise mindestens 12, oder beispielsweise mindestens 16 Prozessoren, beispielsweise Prozessorkarten, pro Meter angeordnet werden können.

Die Rechenanlage kann mehreren Racks aufweisen (z.B. zwischen 5 bis 16 Racks), in denen Serverhardware verbaut ist. Jedes Rack kann beispielsweise eine Server-Aufnahme gemäß einem 19-Zoll-Standard oder einem 21-Zoll-Standard (z.B. der sogenannte "Open Compute-Standard" aufweisen. Die Rechenanlage kann derart eingerichtet sein, dass dieser im Wesentlichen flüssigkeitsgekühlt ist.

In verschiedenen Ausführungsformen sind die Gestelle so ausgebildet, dass sie ein Aufnehmen von Prozessoren in mehreren horizontalen Reihen über die gesamte Höhe des Raums ermöglichen. Beispielsweise können hierzu geeignete Regale, beispielsweise zum Aufnehmen von Prozessorracks und/oder Servern verwendet werden, wobei beispielsweise die horizontalen Reihen die gesamte Innenhöhe des Raums ausfüllen. So werden eine besonders hohe Prozessordichte und eine besonders hohe Anzahl von Prozessoren erreicht.

In verschiedenen Ausführungsformen können mindestens 30 Prozessoren, bzw. Prozessorkarten, pro m² (Quadratmeter), beispielsweise mindestens 60 Prozessoren, bzw. Prozessorkarten, pro m², z.B. mindestens 100 Prozessoren, bzw. Prozessorkarten, pro m², z.B. mindestens 150 Prozessoren, bzw. Prozessorkarten, pro m² angeordnet werden. Beispielsweise kann eine solche Anordnung von Prozessoren, die einer hochdichten Anordnung entspricht, durch eine entsprechende Anordnung in mehreren horizontalen Reihen erreicht werden.

Zum Versorgen der Rechenanlage kann der RZ mehrere Versorgungspfade mit einer Versorgungsschnittstelle aufweisen, die eingerichtet ist, dem RZ von außerhalb zumindest ein Medium zuzuführen. Das Medium kann beispielsweise ein Kühlfluid (z.B. eine Kühlflüssigkeit und/oder ein Kühlgas), elektrische Energie, und/oder ein Kommunikationssignal (z.B. ein Netzwerksignal) sein. Jeder Versorgungspfad kann eingerichtet sein, mit der Rechenanlage in funktioneller Wechselwirkung zu stehen und das jeweils zugeführte Medium an die Rechenanlage weiterzugeben und/oder mit dieser auszutauschen. Die Menge an Ver- und Entsorgungspfaden innerhalb des Raums kann hierin auch als Infrastruktur bezeichnet sein. Je nach Typ des Mediums (Kühlfluid, elektrische Energie, und/oder Kommunikationssignal) kann die Infrastruktur als Kühl-Infrastruktur, Energieversorgung-Infrastruktur (z.B. Stromversorgung-Infrastruktur) oder Telekommunikation-Infrastruktur bezeichnet sein. Beispielsweise kann die Kühl-Infrastruktur eingerichtet sein, der Rechenanlage entlang des Versorgungspfads thermische Energie zu entziehen (auch als Kühlen bezeichnet). Optional können versorgungskritische Versorgungspfade oder Komponenten des Raums redundant vorhanden sein.

Die Redundanz bezeichnet das Vorhandensein funktional gleicher oder vergleichbarer Ressourcen eines technischen Systems, von denen bei einem störungsfreien Betrieb im Normalfall nicht alle benötigt werden. Eine funktionelle Redundanz kann aufweisen, dass zum Betrieb benötigte Versorgungspfade mehrfach parallel ausgelegt sind, damit beim Ausfall eines Versorgungspfades oder im Falle der Wartung ein anderer Versorgungspfad den Betrieb unterbrechungsfrei gewährleistet. Optional können die zueinander redundanten Versorgungspfade voneinander räumlich separiert sein, z.B. durch Schutzwände und/oder räumlichen Abstand (z.B. indem diese auf einander gegenüberliegenden Seiten des Raums angeordnet sind) um weitere Sicherheiten zu gewährleisten.

Als Redundanz eines Elements, das zum Betrieb der Rechenanlage verwendet wird (z.B. eines Versorgungspfads, einer Komponente dessen, oder eines Prozessors) kann hierin beispielsweise verstanden werden, dass zumindest eine funktional gleiche oder vergleichbare Kopie des Elements vorhanden ist, und das Element und dessen Kopie auch derart eingerichtet sind, dass zwischen diesen umgeschaltet werden kann, z.B. ohne dass der Betrieb der Rechenanlage unterbrochen werden muss. Das Element und dessen Kopie können dann anschaulich zueinander redundant (auch als zueinander redundantes Paar bezeichnet) eingerichtet sein.

Das Umschalten zwischen zwei zueinander redundanten Elementen (z.B. von einem ersten Versorgungspfad auf einen dazu redundanten Versorgungspfad) kann beispielsweise automatisiert erfolgen, wenn eine Fehlfunktion in dem aktiven Element erkannt wurde. Die Fehlfunktion kann beispielsweise als kritisch erkannt werden, d.h. dass diese zu einem Ausfall oder Teilausfall der Rechenanlage führen könnte. Das Umschalten kann beispielsweise mittels eines Ausfallschalters (z.B. eines Transferschalters) erfolgen, z.B. automatisiert. Eine Vorzertifizierung kann beispielsweise erfordern, dass das Rechenzentrum eine zumindest teilweise redundante Infrastruktur aufweist. Alternativ oder zusätzlich, z.B. wenn in dem Raum selbst nur einen Teil der typischen RZ-Komponenten angeordnet sind (z.B. können die Trafos, Generatoren und die Unterbrechungsfreie Stromversorgung (USV) zentralisiert und/oder außerhalb dessen angeordnet werden), können die redundanten Komponenten und Versorgungspfade zumindest einen Teil der Anforderungen für die Vorzertifizierung erfüllen (z.B. kann der Raum zwei redundante Elektro-Unterverteilungen und zwei Versorgungswege aufweisen), so dass eine Vorzertifizierung prinzipiell die erwartete Verfügbarkeit bescheinigt, wenn außerhalb des Raums ebenfalls die Anforderungen erfüllt werden (z.B. Klassifiziert als "unterstützt Verfügbarkeitsklasse x", wobei x=1, 2, 3 oder 4 ist). Ein Effekt der Vorzertifizierung ist, dass die Container nach ihrem Transport an den Standort des RZ, nicht mehr zertifiziert werden müssen. Dies ermöglicht es, das RZ schneller und mit weniger Aufwand am Zielort in Betrieb zu nehmen.

Gemäß verschiedenen Ausführungsformen kann die Redundanz als N+1-Redundanz ausgebildet sein. Eine N+1-Redundanz bezeichnet, dass die Rechenanlage maximal (z.B. genau) N Versorgungspfade zum Betrieb benötigt, wobei mindestens N+1 Versorgungspfade in dem Raum vorhanden sind. Der N+1te Versorgungspfad kann als passiver Standby-Versorgungspfad eingerichtet sein. Fällt einer der N Versorgungspfade aus oder muss gewartet werden, so kann dessen Funktion von dem N+1-ten Versorgungspfad übernommen werden, z.B. ohne dass der Betrieb der Rechenanlage unterbrochen werden muss. Fallen zwei der N Versorgungspfade aus, kann dies einen Ausfall oder Teilausfall der Rechenanlage zur Folge haben (entspricht beispielsweise Verfügbarkeitsklasse "VK 3" nach DIN EN 50600 oder "Tier 3" nach nordamerikanischem Standard des Uptime-Instituts). Dem könnte entgegengewirkt werden, indem eine höhere Redundanz verwendet wird, z.B. indem die Redundanz als parallel-Redundanz ausgebildet ist. Bei der parallel-Redundanz sind mindestens 2·N Versorgungspfade vorhanden, z.B. 2·(N+1) Versorgungspfade (entspricht beispielsweise Verfügbarkeitsklasse "VK 4" nach DIN EN 50600 oder "Tier 4" nach nordamerikanischem Standard des Uptime-Instituts).

Einpfadige Versorgungswege ohne Dopplung von Komponenten können hingegen "VK 1" bzw. "Tier 1" entsprechen, wobei zusätzlich zu den Verfügbarkeitsklassen weitergehende bautechnische Anforderungen (z.B. Einbruchsschutz, Brandschutz, u.v.m.) in den Normen definiert sein können. Das RZ kann beispielsweise gemäß "VK 2" bzw. "Tier 2" Standard oder gemäß "VK 3" bzw. "Tier 3" Standard errichtet sein.

In verschiedenen Ausführungsformen weist der Raum ein hermetisch (z.B. luftdicht) abgedichtetes und/oder thermisch isoliertes Inneres (auch als Luftzirkulationsbereich bezeichnet) auf, in welchem die Luft angeordnet ist und/oder strömt. Somit wird ein Austausch von Luft zwischen dem Luftzirkulationsbereich und einem Äußeren des Raums gehemmt. Beispielsweise kann die Luft in physischem Kontakt mit dem Rechenzentrum, einer oder mehr als einer Infrastruktur und/oder dem Wärmetauscher sein. Der Raum kann optional eingerichtet sein, die hermetische Abdichtung in Reaktion auf einen Havarie-Ereignis (z.B. Feuerausbruch) aufzuheben. Es kann allerdings auch die hermetische Abdichtung (z.B. unidirektional) aufrechterhalten werden, so dass eine im Inneren des Raums befindliche Gaslöschanlage eine bessere Wirkung entfaltet. Beispielsweise kann Rechenanlage angeordnet ist.

Hierin werden verschiedene Flüssigkeit-Kreisläufe beschrieben, in den jeweils eine Flüssigkeit zirkuliert. Die Flüssigkeit kann als Kühlmedium dienen, d.h. dessen Strömung kann thermische Energie transferieren. Die Flüssigkeit-Kreisläufe werden gemäß ihrem Temperaturniveau (anschaulich die Temperatur ihrer Flüssigkeit) unterschieden in Heißflüssigkeit bzw. Heißflüssigkeit-Kreislauf und Kaltflüssigkeit bzw. Kaltflüssigkeit-Kreislauf. Die Flüssigkeit kann beispielsweise Wasser aufweisen oder daraus gebildet sein. Es kann aber auch eine andere Flüssigkeit verwendet werden, z.B. Öl, Petroleum, Ethanol oder ein flüssiges Gemisch mehrerer Flüssigkeiten. Wasser weist eine sehr hohe spezifische Wärmekapazität bei niedriger Dichte auf, was das Wärmeleistungsentzugsvermögen verbessert.

In verschiedenen Ausführungsformen ist das RZ mit einem Kaltflüssigkeit-Kreislauf ausgestattet, dessen thermische Energie (kurz auch als Wärme bezeichnet) mittels der Wärmepumpe dem Heißflüssigkeit-Kreislauf zugeführt wird. Ein Effekt dieses Wärmetransports ist es, dass der durch den Rechenbetrieb entstandene Abwärme zusätzlich die Abwärme der luftgekühlten Komponenten des Raums zugeführt werden kann. So ist es möglich, dass die im RZ verbrauchte elektrische Leistung zum Großteil (z.B. zu mehr als ungefähr 80%, 90% oder 95%) in Form von Wärme von der Heißflüssigkeit aufgenommen wird. Dies verbessert die Energiebilanz des RZ.

In verschiedenen Ausführungsformen kann das Temperaturniveau des Heißflüssigkeit-Kreislaufs eine Anwendung in Nah- und Fernwärmenetzen ermöglichen. In diesen Netzen werden Temperaturen im Bereich von 80-130°C verwendet. Einem solchen Netz kann somit die Abwärme des RZ zugeführt werden, z.B. über eine Schnittstelle, die eine oder mehr als eine weitere Wärmepumpe aufweist. Mittels der oben beschriebene Mechanismen kann sehr energieeffizient eine Rücklauftemperaturanhebung im Rücklauf des Nah- und/oder Fernwärmenetz erzielt und so der (meist fossiler Brennstoffe) für die anschließende Anhebung auf Solltemperatur maßgeblich reduziert werden.

Gemäß verschiedenen Ausführungsformen wird ein RZ für den Außeneinsatz bereitgestellt (auch als Outdoor-Rechenzentrum bezeichnet). Das RZ kann auf einem Container und/oder einer Modulbauweise basieren. Ferner kann das Outdoor-RZ ein in sich komplett geschlossenes und zur Verminderung der Umwelteinflüsse, wie Thermik, Luftfeuchtigkeit und Partikel, nach außen isoliertes System sein, was die möglichen Einsatzmöglichkeiten erhöht. Beispielsweise kann das Outdoor-RZ weitestgehend unabhängig von der Klimazone aufgestellt werden.

Beispielsweise kann der Anteil der Wärmemenge, welcher der oder jeder Server in die Flüssigkeit (z.B. Wasser) abgibt, an der gesamten elektrischen Leistungsaufnahme des Servers, größer sein als ungefähr 30%, z.B. ungefähr 50% oder mehr, beispielsweise in einem Bereich von ungefähr 80% bis ungefähr 100%). Wasser als Kühlmedium steigert die maximal abführbare Wärmeleistung (auch als Wärmeleistungsentzugsvermögen bezeichnet).

Die Leistungsaufnahme der Rechenanlage kann beispielsweise mindestens ungefähr 100 kW (Kilowatt) sein, beispielsweise ungefähr 150 kW oder mehr, beispielsweise ungefähr 200 kW oder mehr, beispielsweise ungefähr 250 kW oder mehr oder beispielsweise ungefähr 500 kW oder mehr. Die Energieversorgung-Infrastruktur kann in verschiedenen Ausführungsformen eingerichtet sein, das Versorgen der Rechenanlage mit einer elektrischen Leistung von mindestens der Leistungsaufnahme der Rechenanlage (z.B. mindestens dem Doppelten davon) bereitzustellen. Die Kühl-Infrastruktur kann in verschiedenen Ausführungsformen eingerichtet sein, mittels des Heißflüssigkeit-Kreislaufs ein Wärmeleistungsentzugsvermögen von mindestens der Leistungsaufnahme der Rechenanlage (z.B. mindestens dem Doppelten davon) bereitzustellen.

Das RZ kann zumindest ein Serverrack (auch als Rack bezeichnet) aufweisen, dessen Rechentechnik primär flüssigkeitsgekühlt ist. Der primäre Abwärmeanteil kann der Hauptversorgung (der sogenannten Heißleitung) zugeführt werden und kann an der externen Schnittstelle (auch als Heißflüssigkeit-Anschluss bezeichnet) des RZ einer Abwärmenutzung oder sehr energieeffizienten Kühlung (z.B. Freiluftkühlung und/oder Hybridkühlung) zugeführt werden. Die Bereitstellung eines Niedertemperatur-Niveaus (der Kaltflüssigkeit) zur Einhaltung der notwendigen Betriebstemperaturen der elektronischen Komponenten kann mittels einer Wärmepumpe erfolgen. Die Wärmepumpe kann mittels elektrischer Leistung die Kaltflüssigkeit auf das Niedertemperatur-Niveau bringen (anschaulich eine kleine Temperatur), welche wiederum durch einen Gas-Flüssigkeits-Wärmetauscher an die Luft innerhalb des Raums übergeben werden kann. Das Pumpen der Wärme mittels der Wärmepumpe unter Einsatz elektrischer Energie generiert in der Wärmepumpe eine thermische Leistung, die wieder dem Heißflüssigkeit-Kreislauf zugeführt werden kann. Somit ist es möglich, z.B. bei einer zusätzlichen Wärmeisolierung nahezu 100% der erzeugten Abwärme in der Heißflüssigkeit zu binden und beispielsweise einer Wiederverwendung zuzuführen. Die Wärmepumpe kann optional redundant ausgeführt werden, um bei einem Ausfall einer Wärmepumpe einen Stillstand der Server vermeiden zu können.

Gemäß verschiedenen Ausführungsformen wird ein geschlossenes RZ (z.B. einen Container oder eine andere Moduleinheit aufweisend) bereitgestellt mit überwiegend flüssigkeitsgekühlten Serverkomponenten in Kombination mit mindestens zwei ergänzenden und redundanten Wärmepumpen. Dieses RZ ist weitestgehend umgebungsunabhängig mit sehr geringem Wartungsaufwand und langen störungsfreien Betrieb.

Gemäß verschiedenen Ausführungsformen kann zumindest eine der zwei Wärmepumpen eine regelbare Wärmepumpe sein. Dies ermöglicht eine Steuerung der Raumtemperatur gemäß einem Sollwert, z.B. derart, dass für den Wartungsfall eine andere Temperatur als für den normalen Betrieb einstellt wird.

Optional kann eine wasserseitige Regelung erfolgen, die beispielsweise ein Absperrventil hinter einem Wärmetauscher auf der Verbraucherseite (also Raumausgangsseite) so steuert, dass eine vorgegebene Temperatur (auch als Ausgangstemperatur bezeichnet) der Heißflüssigkeit konstant gehalten wird. Sinkt die Temperatur der Heißflüssigkeit, kann das Regelventil den Durchfluss der Heißflüssigkeit durch den Wärmetauscher senken. Damit wird gewährleistet, dass immer genau so viel Energie wasserseitig abgeführt wird, wie elektrische Energie im Raum in Wärmeenergie umgewandelt wird.

Gemäß verschiedenen Ausführungsformen kann das RZ einen Raum und darin zumindest eine (einreihige oder mehrreihige) Serverreihe aufweisen, die sich beispielsweise parallel zur langen Seite des Raums (z.B. eines Containers) oder senkrecht dazu erstreckt. Optional kann der Raum unterteilt sein mittels Zwischenwänden in einen Elektrobereich, einen Hydraulikbereich, einen Netzwerkbereich und einen Serverbereich. Optional kann pro Serverreihe (z.B. Recheneinheit) mindestens eine Wärmepumpe bereitgestellt sein.

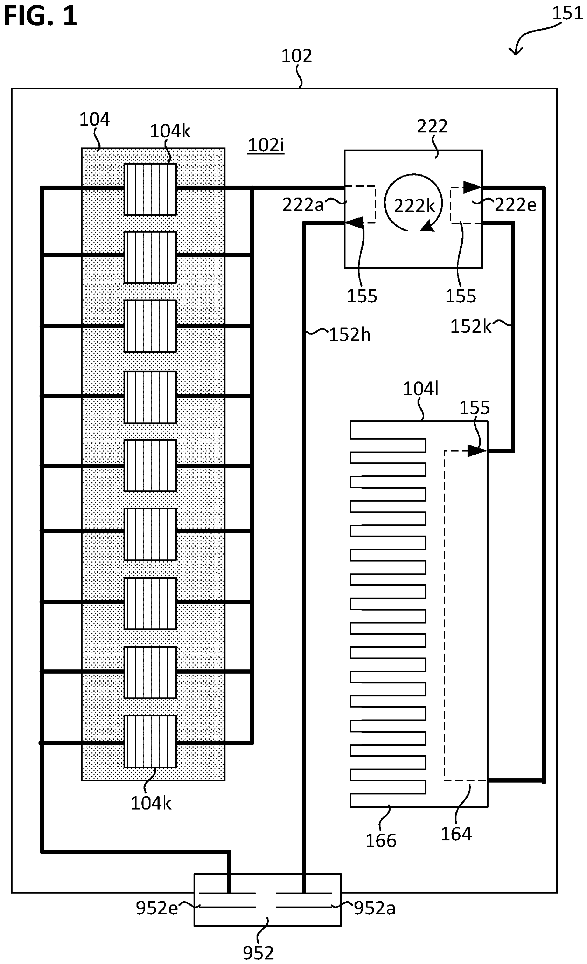

**Fig.1** veranschaulicht ein RZ 151 gemäß verschiedenen Ausführungsformen in einem schematischen Aufbaudiagram. Das RZ 151 kann im Inneren 102i eines Raums 102 (beispielsweise eines Containers 102) eine Rechenanlage 104 aufweisen, welche eine Vielzahl (z.B. mindestens 10, mindestens 100 oder mindestens 1000) Prozessoren aufweist, von denen jeder Prozessor mit einem Kühlkörper 104k gekoppelt ist. Jeder Kühlkörper 104k kann ein thermisch leitfähiges Material (z.B. Kupfer) aufweisen, das von einem Hohlraum durchdrungen ist. Als thermisch leitfähig kann verstanden werden, dass ein Körper und/oder Material eine Wärmeleitfähigkeit von mehr als ungefähr 200 (oder 300) Watt pro Meter und Kelvin (W/m·K) aufweist. Jeder der Kühlkörper 104k kann in thermisch leitfähigen Kontakt mit einem oder mehr als einem Prozessor sein. Ein thermisch leitfähiger Kontakt kann einen thermischen Widerstand von weniger als 1 K/W aufweisen und/oder dielektrisch eingerichtet sein. Der thermisch leitfähige Kontakt kann beispielsweise mittels eines Polymers bereitgestellt sein oder werden.

Im Inneren 102i des Raums 102 können eine Wärmepumpe 222 und ein Gas-Flüssigkeit-Wärmetauscher 104l angeordnet sein. Als Wärmepumpe 222 (auch als Kraftwärmemaschine bezeichnet) kann eine Vorrichtung verstanden werden, welche eingerichtet ist, ihrer kälteren Eingangsseite 222e (auch als Kaltseite bezeichnet) thermische Energie zu entziehen und diese (z.B. zusammen mit der Antriebsenergie) ihrer wärmeren Ausgangsseite 222a (auch als Warmseite bezeichnet) zuzuführen. In verschiedenen Ausführungsformen weist die Wärmepumpe dazu einen Fluidkreislauf 222k auf, in welchem ein geeignetes Fluid (z.B. ein Fluid, das im Kreislauf 222k einen flüssigen sowie einen gasförmigen Zustand erreichen kann, z.B. Propan) zirkuliert. Komponenten des Fluidkreislaufs 222k sind z.B. ein Verdampfer, eine Drossel, ein Kondensator und ein Verdichter. Das Fluid wird beispielsweise so gewählt, dass es im Verdampfer durch die Wärmezufuhr aus der Eingangsseite 222e verdampft und nach einem Verdichten (im Verdichter) im Kondensator wieder kondensiert unter Wärmeabgabe an die Ausgangsseite 222a. Die Drossel wird beispielsweise verwendet um eine kontrollierte Entspannung des Fluids zu ermöglichen.

Als Wärmetauscher 104l kann eine Vorrichtung verstanden werden, welche thermische Energie von einem ersten Fluidstrom auf einen zweiten Fluidstrom überträgt. Der Wärmetauscher 104l kann beispielsweise passiv eingerichtet sein, so dass der Wärmestrom im Wesentlichen nur von dem Temperaturunterschied zwischen dem ersten Fluidstrom und dem zweiten Fluidstrom bewirkt wird. Bei einem Gas-Flüssigkeit-Wärmetauscher 104l (vereinfacht auch als Wärmetauscher 104l bezeichnet) kann das erste Fluid eine Flüssigkeit und das zweite Fluid ein Gas sein. Beispielsweise kann der Wärmetauscher 104l eine Rohrleitung 164 aufweisen, durch welche die Flüssigkeit hindurch strömt, und eine Vielzahl von Lamellen 166, durch welche das Gas (z.B. die Luft) hindurch strömt. Die Lamellen können mit der Rohrleitung 164 thermisch gekoppelt sein, z.B. indem die Rohrleitung 164 quer durch die Lamellen hindurch erstreckt ist. Der Wärmetauscher 104l kann beispielsweise passiv eingerichtet sein.

Ferner kann das RZ 151 (z.B. innerhalb des Raums 102) einen Heißflüssigkeit-Kreislauf 152h und einen Kaltflüssigkeit-Kreislauf 152k aufweisen. Als Flüssigkeit-Kreislauf (z.B. der Kaltflüssigkeit-Kreislauf 152k bzw. der Heißflüssigkeit-Kreislauf 152h) kann hierin ein System verstanden werden, welches eingerichtet ist, eine Flüssigkeit entlang eines Strömungspfades 155 durch den Raum 102 hindurch zu führen. Der Flüssigkeit-Kreislauf kann mit zumindest einer Komponente (z.B. der Wärmepumpe 222) des RZ 151 derart gekuppelt sein, dass der Strömungspfad 155 durch diese Komponente hindurch geführt ist, d.h. dass die Flüssigkeit dieser zugeführt und wieder entzogen wird. Beispielsweise können mehrere Komponenten (z.B. die Wärmepumpe 222 und der Wärmetauscher 104l) in Reihe bezüglich des Strömungspfads 155 geschaltet sein. Alternativ oder zusätzlich können mehrere Komponenten (z.B. die Kühlkörper 104k) parallel zueinander bezüglich des Strömungspfads 155 geschaltet sein. Als Bezugspunkt kann dazu beispielsweise eine Pumpe des Flüssigkeit-Kreislaufs dienen.

Der Heißflüssigkeit-Anschluss 952 kann einen Eingangsflansch 952e und einen Ausgangsflansch 952a aufweisen. Dadurch wird es ermöglicht, dem Raum 102 die Flüssigkeit des Heißflüssigkeit-Kreislaufes 152h zu entziehen Ausgangsflansch hindurch) und wieder zuzuführen (durch den Eingangsflansch hindurch). An dem Heißflüssigkeit-Anschluss 952 kann der Strömungspfad optional unterbrochen oder verzweigt sein.

Der Kaltflüssigkeit-Kreislauf 152k kann im Allgemeinen keinen Anschluss oder weniger Anschlüsse an der Außenseite des Raums 102 aufweisen als der Heißflüssigkeit-Kreislauf 152h.

Der Heißflüssigkeit-Kreislauf 152h kann mit der Warmseite 222a der Wärmepumpe 222 gekoppelt sein. Der Kaltflüssigkeit-Kreislauf 152k kann mit der Kaltseite 222e der Wärmepumpe 222 gekoppelt sein.

Der Kaltflüssigkeit-Kreislauf 152k kann den Wärmetauscher in Reihe mit der Wärmepumpe 222 koppeln. Der Heißflüssigkeit-Kreislauf 152h kann die mehreren Kühlkörper 104k in Reihe mit der Wärmepumpe 222 koppeln.

Im Folgenden wird zum einfacheren Verständnis auf Wasser als Heißflüssigkeit und Kaltflüssigkeit Bezug genommen. Es kann prinzipiell aber auch eine andere Flüssigkeit ein Gemisch mehrere Flüssigkeiten als Heißflüssigkeit bzw. Kaltflüssigkeit dienen. Wasser hat eine hohe Wärmekapazität und kann daher eine hohe Effizienz bereitstellen.

Das RZ 151 kann optional mehrere solcher Räume 102 aufweisen, wie im Folgenden beschrieben wird. Die Komponenten, die mittels des Kaltflüssigkeit-Kreislaufs 152k und des Heißflüssigkeit-Kreislaufs 152h miteinander thermisch und/oder fluidleitend gekoppelt sind, können Teil der Kühl-Infrastruktur 114 sein.

In verschiedenen Ausführungsformen ist die oder jede Wärmepumpe 222 eine Hochtemperatur-Wärmepumpe. Je nach Wärmepumpe kann dann dem Kaltflüssigkeit-Kreislauf 152k bei einer Temperatur (der Kaltflüssigkeit) von beispielsweise mindestens 30°C, beispielsweise mindestens 40°C, beispielsweise mindestens 50°C, beispielsweise mindestens 60°C Wärme entzogen werden und diese Wärme auf ein höheres Temperaturniveau von beispielsweise mindestens 50°C, beispielsweise mindestens 60°C, beispielsweise mindestens 70°C oder 85°C angehoben werden, bei dem es dem Heißflüssigkeit-Kreislauf 152h zugeführt wird.

Gemäß verschiedenen Ausführungsformen kann der Raum 102 als ein Container 102 eingerichtet sein. Dann können die Wände des Raumes die Containerwände, der Boden des Raums der Containerboden und die Decke des Raumes die Containerdecke sein. Im Folgenden wird unter anderem auf einen Raum 102 Bezug genommen, der beispielsweise als ein Container 102 eingerichtet ist. Das Beschriebene kann in Analogie auch für einen anders eingerichteten Raum 102 gelten, z.B. für Raum eines Gebäudes und/oder einen Raum mit Wänden aus Stein.

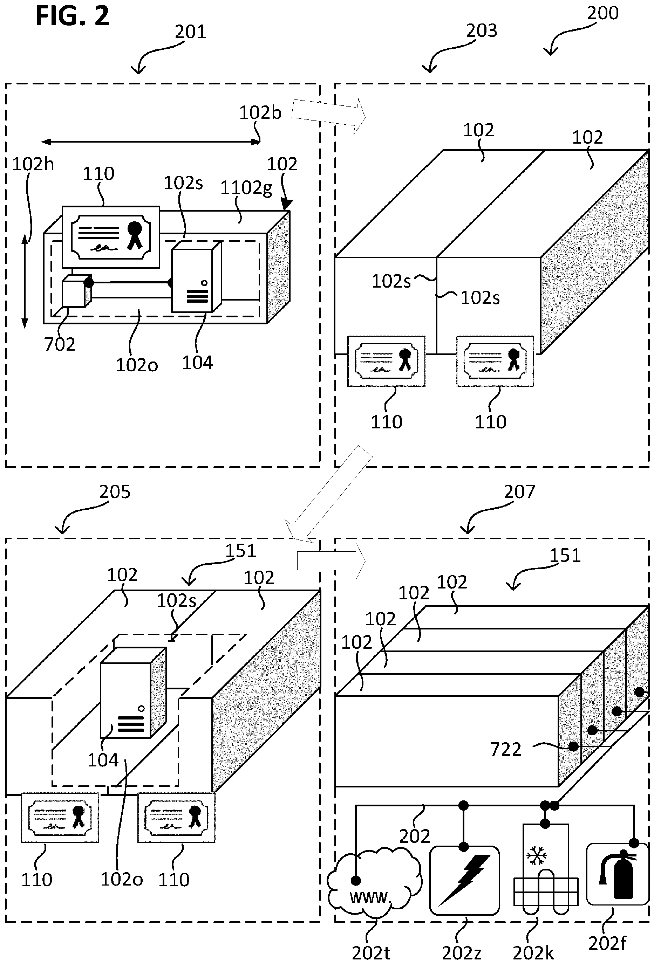

**Fig.2** veranschaulicht ein Verfahren 200 gemäß verschiedenen Ausführungsformen in einem schematischen Ablaufdiagramm zur Handhabung von mehreren Containern 102 eines Container-RZ 151. Jeder Container 102 kann ein Gehäuse 1102g aufweisen, welches aneinandergrenzende (z.B. vier) Seitenwände, eine Decke und einen Boden aufweisen kann, die ein Inneres des Containers umgeben. Von den Seitenwänden des Containers 102 können optional mehrere Seitenwände 102s im Wesentlichen vollständig geöffnet werden (auch als Loswände 102s bezeichnet). Der Container 102 kann ferner im Inneren eine oder mehr als eine Infrastruktur 702 zur Verteilung eines Mediums aufweisen. Im Folgenden kann zum einfacheren Verständnis allgemeiner auf eine Infrastruktur 702 des Containers 102 Bezug genommen sein, wobei das für die Infrastruktur 702 Beschriebene für die Energie-Infrastruktur, die Kühl-Infrastruktur und/oder die Telekommunikation-Infrastruktur (z.B. in Analogie) gelten kann. Dasselbe kann in Analogie allerdings auch für eine oder mehr als eine der anderen Infrastrukturen 702 des Containers 102 gelten.

Die Infrastruktur 702 des oder jedes Containers 102 kann hinsichtlich einer Ausfallsicherheit der Rechenanlage 104 einzeln vorzertifiziert 110 sein. Es können optional mehrere Infrastrukturen 702 oder der ganze Container als Teil eines RZ oder der Container mit zusätzlichen Technik-Containern vorzertifiziert sein.

Die Vorzertifizierung 110 kann anschaulich repräsentieren, wie groß die Ausfallsicherheit der Rechenanlage ist. Beispielsweise kann die Ausfallsicherheit (auch als Verfügbarkeit bezeichnet) mehr als 95% betragen, z.B. mindestens ungefähr 98,97%, z.B. mindestens ungefähr 99%, z.B. mindestens ungefähr 99,9% (auch als hohe Ausfallsicherheit bezeichnet), z.B. mindestens ungefähr 99,99% (auch als sehr hohe Ausfallsicherheit bezeichnet), z.B. mindestens ungefähr 99,999%. Die Ausfallsicherheit kann je nach Zertifizierungstyp klassifiziert sein oder werden, d.h. in Klassen (auch als Verfügbarkeitsklasse bezeichnet) eingeteilt sein.

Beispielsweise kann eine Vorzertifizierung gemäß DIN EN 50600 (von 2013, z.B. DIN EN 50600-1 von 2013, oder DIN EN 50600-2-2 von 2014 oder DIN EN 50600-2-3 von 2015) und/oder gemäß amerikanischer Tier-Klassifikation (z.B. von 2015) verwendet werden. Es können aber auch andere (z.B. gewerbliche) Zertifizierungstypen verwendet werden, z.B. eine Bitcom-Zertifizierung (z.B. gemäß Bitcom-Leitfaden 2013) oder eine InfraOpt-Zertifizierung (von 2017). Je nach Zertifizierungstyp bzw. Verfügbarkeitsklasse können verschiedene Anforderungen an die Vorzertifizierung erfüllt sein, beispielsweise mindestens eine N+1-Redundanz (oder 2·N-Redundanz) der Infrastruktur 702.

Das Verfahren 200 kann in 101 aufweisen: Bereitstellen zumindest eines (d.h. eines oder mehr als eines) Containers 102. Das Bereitstellen 101 kann optional in 103 aufweisen: Verlagern des zumindest einen Containers 102, z.B. zu Land, Wasser und/oder Luft. Das Verfahren 200 kann in 103 beispielsweise aufweisen: Anordnen mehrerer Container 102 derart relativ beieinander, dass jeweils zwei Container 102 der mehreren Container 102 einander unmittelbar benachbart angeordnet sind. Beispielsweise können diese mit zumindest zwei (z.B. stirnseitigen oder längsseitigen) Loswänden 102s einander zugewandt angeordnet sein. Das Verfahren 200 kann in 105 beispielsweise aufweisen: Öffnen einer der mehreren Loswände 102s des oder jedes Containers 102, welche beispielsweise einem anderen Container 102 der mehreren Container 102 zugewandt ist. Der oder jeder Container 102 kann derart eingerichtet sein, dass beim Öffnen der Loswand 102s die Vorzertifizierung des Containers 102 (z.B. dessen Energie-Infrastruktur 106) erhalten bleibt. Dazu kann die oder jede Loswand 102s des Containers 102 beispielsweise frei von Elementen sein, welche die Vorzertifizierung beeinflussen, z.B. welche die Erfüllung der Anforderung gemäß der Vorzertifizierung beeinflussen. Damit kann anschaulich erreicht werden, dass nach dem Verbinden des Inneren der mehreren Container 102 keine Zertifizierung des Containers 102 vorgenommen werden muss. Dies beschleunigt den Einsatz des RZ 151, welches die mehreren Container 102 aufweist.

Das Verfahren 200 kann in 107 aufweisen: Ankoppeln des zumindest einen Containers 102 untereinander und/oder mit zumindest einer externen Versorgungsanordnung 202. Die oder jede Versorgungsanordnung 202 kann eine oder mehr als eine Versorgungsstruktur (auch als Versorgung bezeichnet) aufweisen, z.B. optional eine Telekommunikationsversorgung 202t, optional ein Energieversorgung 202z, optional eine Heißwasserversorgung 202k (allgemeiner eine Heißflüssigkeitsversorgung) und/oder optional eine Gaslöschversorgung 202f. Das Ankoppeln einer Infrastruktur 702 kann im Allgemeineren mittels einer Versorgungsschnittstelle 722 erfolgen, an welcher die Infrastruktur entsprechende Anschlüsse aufweist.

Beispielsweise weist die Telekommunikation-Infrastruktur mehrere Netzwerkleitungen auf, welche die Versorgungsschnittstelle 722 mit der Rechenanlage 104 koppeln zum Verbinden der Vielzahl von Prozessoren mit einem lokalen und/oder globalen Netzwerk (z.B. dem Internet). Beispielsweise weist die Kühl-Infrastruktur 114 mehrere Rohrleitungen (z.B. Rohre für Vor- und Rücklauf) auf, welche die Versorgungsschnittstelle 722 mit der Rechenanlage koppeln, so dass dem Inneren des Containers thermische Energie entzogen werden kann.

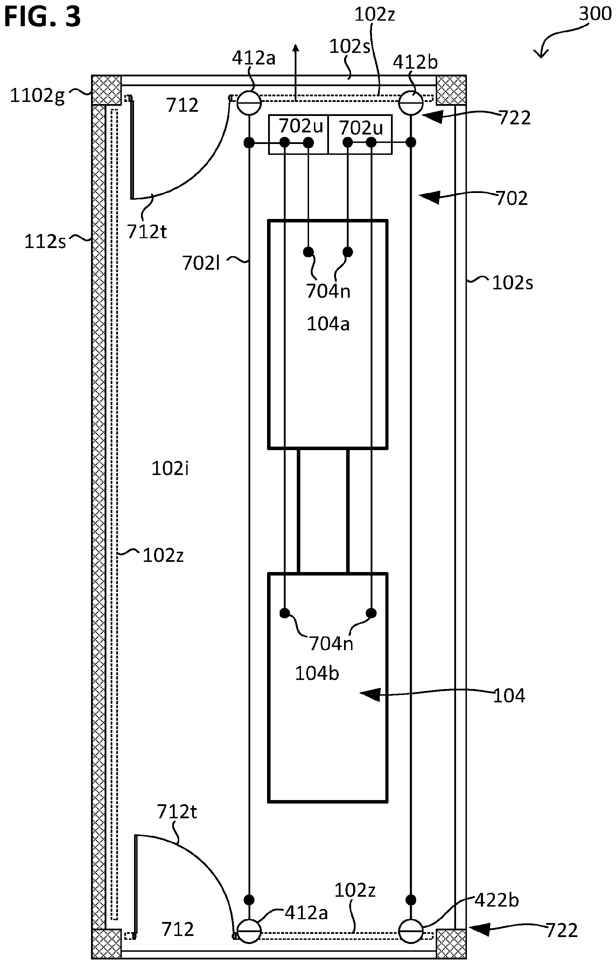

**Fig.3** veranschaulicht ein Container-RZ 151 gemäß verschiedenen Ausführungsformen in einem schematischen Aufbaudiagram 300. Bei dem Container-RZ 151 kann der oder jeder Raum 102 als Container 102 ausgebildet sein.

Der oder jeder Container (z.B. ein ISO-Container) des RZ kann beispielsweise im Einklang mit der ISO Norm 668 ausgebildet sein oder werden. Dies hat die Wirkung, dass hierbei ein Transport der Container auf Schiffen, Bahnen und Lastkraftwagen standardisiert und damit einfach möglich ist. In verschiedenen Ausführungsformen kann der Container eine äußere Länge von 13.716 m (45ft), 12.192 m (40ft, z.B. als Standardcontainer oder Seecontainer), 9.125 m (30ft), 6.058 m (20ft, z.B. als Standardcontainer oder Seecontainer), 2.991 m (10ft), 2.438 m (8ft) oder 1.968 m (6ft), eine äußere Höhe von 2.591 m (z.B. als Standardcontainer) oder 2.896 m (auch als High-Cube-Container bezeichnet), und eine äußere Breite von 2.438 m aufweisen. Beispielsweise hat ein so genannter 20ft-Container eine äußere Länge von 6.058 m, eine äußere Höhe von 2.591 m und eine äußere Breite von 2.438 m. Ein so genannter 40ft-Container (z.B. 40ft-HC-Container) hat eine äußere Länge von 12.192 m, eine äußere Höhe von 2.896 m und eine äußere Breite von 2.438 m. In einem Beispiel kann der Container eine äußere Dimension (Länge x Breite x Höhe) von 6.058 m x 2.438 m x 2.896 m haben. Der Container kann eine innere Dimension (Länge x Breite x Höhe des Inneren) von 5.853 m x 2.342 m x 2.697 m haben.

Das Gehäuse 1102g des Containers 102 kann zumindest zwei (z.B. drei) Loswände 102s aufweisen, optional eine oder mehr als eine Festwand 112s. Die Festwand 112s kann beispielsweise entlang einer Längserstreckung des Containers 102 verlaufen und/oder auf einer Längsseite des Containers 102 angeordnet sein. Die Festwand 112s und die zweite Loswand 102s (auch als längsseitige Seitenwände bezeichnet) können einander gegenüberliegend angeordnet sein. Ferner können die erste Loswand 102s und die dritte Loswand 102s (auch als stirnseitige Loswände bezeichnet) einander gegenüberliegend angeordnet sein.

In einer Ausführungsform ist jede im Wesentlichen vollständig zu öffnende Seitenwand (auch als Loswand bezeichnet) des Containers als mehrflüglige, faltbare oder demontierbare Wand ausgebildet. Alternativ oder zusätzlich kann die Loswand so ausgebildet sein, dass sie im Einklang mit der ISO Norm 668 wieder verschlossen werden kann, und/oder dass der Container nicht von anderen Containern unterschieden werden kann. So kann in dieser Ausgestaltung ein Versand des Containers mit üblichen Speditionen und Versandwegen in einfacher Weise mittels Lastkraftwagen, Zügen und Schiffen ermöglicht werden.

Der Container 102 kann ferner eine oder mehr als eine Infrastruktur 702 (z.B. die Energie-Infrastruktur 106, die Kühl-Infrastruktur 114 und/oder die Telekommunikation-Infrastruktur) aufweisen.

Ferner kann das Gehäuse des Containers 102 mehrere Zwischenwände 102z aufweisen, wie nachfolgend genauer beschrieben wird. Jede der Zwischenwände kann beispielsweise eine Wärmedämmung aufweisen und/oder das Innere 102i des Containers 102 hermetisch abriegeln.

Zwischen der Rechenanlage 104 und der ersten Loswand 102s und der dritten Loswand 102s kann beispielsweise jeweils eine stirnseitige Zwischenwand 102z angeordnet sein. Zwischen den zwei stirnseitigen Zwischenwänden 102z können die Rechenanlage 104 und/oder die Versorgungsleitungen 702l der Infrastruktur 702 angeordnet sein. Jede stirnseitige Zwischenwand 102z kann optional eine Türöffnung 712 aufweisen, in der beispielsweise eine Tür 712t (auch als Personentür 712t bezeichnet) angeordnet sein kann. Die Personentür 712t kann eine Sicherheitstür sein. Die Sicherheitstür 712t kann abschließbar, wärmegedämmt und/oder feuerfest und/oder rauchdicht eingerichtet sein.

Ferner kann die Infrastruktur 702 mindestens ein Paar (z.B. zwei Paare) zueinander redundante Versorgungspfade 702u aufweisen, von denen jedes Paar die Versorgungsschnittstelle 722 mit der Rechenanlage 104 koppelt. Beispielsweise kann jede Recheneinheit 104a, 104b der Rechenanlage 104 mit einem Paar zueinander redundante Versorgungspfade 702u gekoppelt sein. Dazu kann die Recheneinheit 104a, 104b beispielsweise eingerichtet sein, zwischen einem Paar zueinander redundanter Infrastruktur-Ankopplungen 704n (z.B. pro Recheneinheit 104a, 104b) der Rechenanlage 104 umzuschalten. Alternativ oder zusätzlich kann die Infrastruktur 702 eingerichtet sein, zwischen den zueinander redundanten Versorgungspfaden 702u eines Paars umzuschalten. Das Umschalten kann beispielsweise mittels eines automatischen Ausfallschalters erfolgen.

Beispielsweise kann die oder jede Versorgungsschnittstelle 722 zumindest ein Paar zueinander redundante Anschlüsse 412a, 412b aufweisen, von denen ein erster Anschluss 412a mittels zumindest einer ersten Versorgungsleitung 702l mit der Rechenanlage 104 (z.B. jeder Recheneinheit 104a, 104b) gekoppelt ist, und von denen ein zweiter Anschluss 412b mittels zumindest einer zweiten Versorgungsleitung 702l mit der Rechenanlage 104 (z.B. jeder Recheneinheit 104a, 104b) gekoppelt ist. Jeder der Versorgungspfade kann beispielsweise mehrere Versorgungsleitungen aufweisen und/oder eine Verteilereinheit, welche die mehreren Versorgungsleitungen mit der Versorgungsschnittstelle 722 koppelt.

Optional kann eine zusätzliche Zwischenwand 102z an der Festwand 112s angeordnet sein, und ein oder mehr als ein Bestandteil des Containers 102, z.B. der Infrastruktur 702, einer Benutzerschnittstelle oder Ähnlichem tragen. Die zusätzliche Zwischenwand 102z ermöglicht es, die Festwand 112s unverändert zu lassen und/oder den Container 102 zusätzlich wärmezudämmen.

Ein oder mehr als ein Medium kann mittels der Versorgungsanordnung 202 lokal bereitgestellt werden, z.B. Heißwasser, eine Niederspannung 400 V (Wechselstrom - AC) erzeugt aus einer Mittelspannung (mittels eines Transformators), einen unterbrechungsfreien Strom (z.B. mittels USV), ein optionales Löschgas.

Die Infrastruktur 702 kann eingerichtet sein, hinsichtlich der Ausfallsicherheit der Rechenanlage 104 die Anforderungen der Verfügbarkeitsklasse 2 oder höher (z.B. der Verfügbarkeitsklasse 3) zu erfüllen und dementsprechend vorzertifiziert sein, z.B. gemäß Tier und/oder gemäß DIN EN 50600.

Die Gehäusestruktur (z.B. Festwand) des Containers 102 kann aus Stahl sein, welche optional eine oder mehr als eine Personentür aufweisen kann. Das Gestell des Containers kann vier Eckstahlträger und deren horizontale Stahl-Verbindungsträger (und optional die Bodenkonstruktion) aufweisen, welche an die Zwischenwände 102z angrenzen.

Die Energie-Infrastruktur 106 kann zwei voneinander separate Unterverteilungsvorrichtung 106u (UV) und/oder voneinander separate Kabeltrassen aufweisen, um beispielsweise die Anforderungen ab Verfügbarkeitsklasse 2 (z.B. Tier 2) zu erfüllen (z.B. Versorgung mit USV-Strom A und B). Die Kabeltrassen können durchgängig durch den ganzen Container 102 im Doppelboden hindurchgeführt werden, um beispielsweise zwei zueinander wegeredundante Versorgungspfade von den Versorgungsschnittstelle 722 an einander gegenüberliegenden Stirnseite des Containers 102 zu ermöglichen. Jeder Versorgungspfad bzw. jede UV 106u kann eingerichtet sein, eine Versorgungsleistung von mindestens 250 kW (Kilowatt) oder weniger bereitzustellen. Beispielsweise kann der Querschnitt der Versorgungsleitungen jedes Versorgungspfads eingerichtet sein, die Versorgungsleistung wahlweise bei 220 V (Volt) oder auch bei 110 V bereitzustellen. Alternativ oder zusätzlich kann jeder Versorgungspfad der Energie-Infrastruktur 106 eingerichtet sein, pro 6 Meter Längserstreckung des Containers 102 eine Leistung von ungefähr 250 kW oder mehr bereitzustellen und/oder in Summe ungefähr 500 kW oder mehr (z.B. bei weniger oder keiner Redundanz) bereitzustellen.

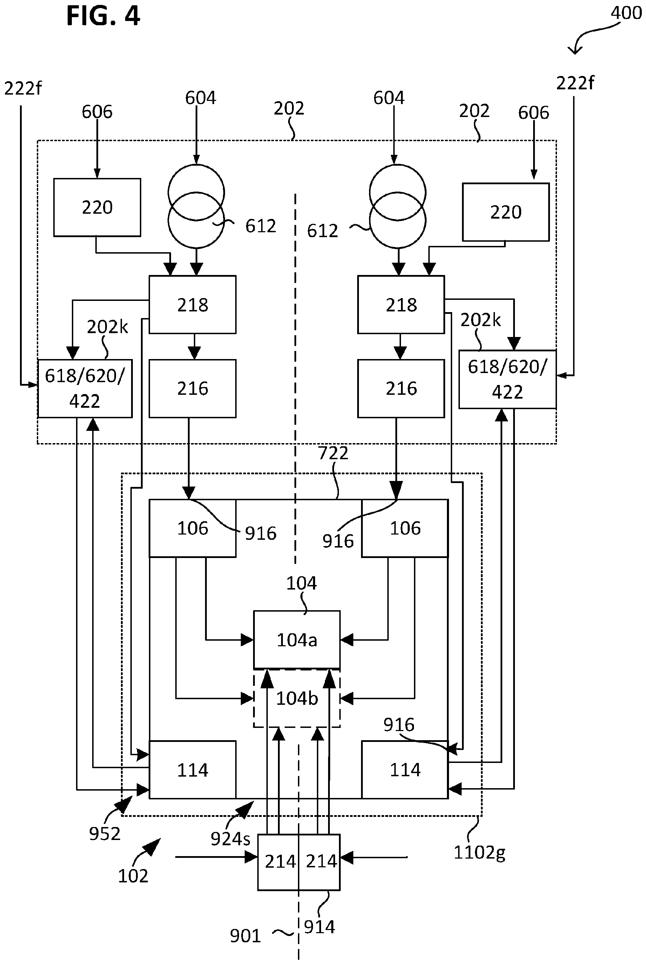

**Fig.4** veranschaulicht ein RZ 151 gemäß verschiedenen Ausführungsformen in einem schematischen Versorgungsdiagram 400 mit schematischer Redundanzpaarung 901. Das RZ 151 kann eine Versorgungsanordnung 202 und den Raum 102 aufweisen. Der Raum 102 kann aber auch ohne die Versorgungsanordnung 202 bereitgestellt sein oder werden. Die Versorgungsanordnung 202 kann ein oder mehr als ein Versorgungsmodul zum Versorgen des RZ 151 aufweisen, wobei das oder jedes Versorgungsmodul optional einen Container aufweisen kann, in welcher die entsprechende Versorgungsstruktur angeordnet ist. Die Versorgungsschnittstelle 722 kann an einer Wand des RZ 151, z.B. an einer Zwischenwand des Containers 102, angeordnet sein.

Die Versorgungsanordnung 202 kann optional mit einer Mittelspannungshauptverteilung 604 und/oder einer optionalen Treibstoffzuführung 606 (z.B. Gas oder Diesel zuführend) gekoppelt sein. Die Versorgungsanordnung 202 kann mehrere modular bereitgestellte Versorgungsvorrichtungen (dann auch als Module bezeichnet) aufweisen, z.B. einen Transformator 612, einen Stromgenerator 220, eine Niederspannungshauptverteilung 218, eine unterbrechungsfreie Stromversorgung 216, eine Normalstromverteilung 616, eine Heißwasserwasserversorgung 618, einen Kühlturm 620, und/oder eine Wärmepumpenanlage 422. Zusätzlich zur Wärmepumpenanlage 422, z.B. alternative zu dem Kühlturm 620, kann eine Fern- oder Nahwärmeleitung 222f angeschlossen sein, um die Abwärme einer Nutzung zuzuführen.

Die Kühl-Infrastruktur 114 (z.B. die Luftklimatisierung 104l aufweisend) kann optional zumindest ein Paar zueinander redundante Versorgungspfade aufweisen, von denen jeder Versorgungspfad einen Heißwasseranschluss 952 (z.B. Flansche aufweisend) an der Versorgungsschnittstelle 722 aufweist. Die Energie-Infrastruktur 106 kann optional zumindest ein Paar zueinander redundante Versorgungspfade aufweisen, von denen jeder Versorgungspfad zumindest eine Unterverteilungsvorrichtung 106u (UV) und/oder zumindest einen Stromeinspeisungsanschluss 916 an der Versorgungsschnittstelle 722 aufweist.

Das Telekommunikationsmodul 202t kann beispielsweise zwei zueinander redundante Telekommunikationsanschlüsse 214 aufweisen. Dementsprechend kann die Telekommunikation-Infrastruktur zumindest ein Paar zueinander redundante Versorgungspfade aufweisen, von denen jeder Versorgungspfad zumindest eine Netzwerkleitung und/oder einen Netzwerkanschluss an der Versorgungsschnittstelle 722 aufweist (z.B. mittels Telekommunikationsschnittstelle 924s). Jede Recheneinheit 104a, 104b der Rechenanlage 104 kann optional mit jedem Paar zueinander redundanter Versorgungspfade der Telekommunikation-Infrastruktur 914, der Energie-Infrastruktur 106 und/oder der Kühl-Infrastruktur 114 gekoppelt sein.

Das RZ 151 gemäß Versorgungsdiagram 400 kann beispielsweise den Anforderungen der Verfügbarkeitsklasse 3 genügen.

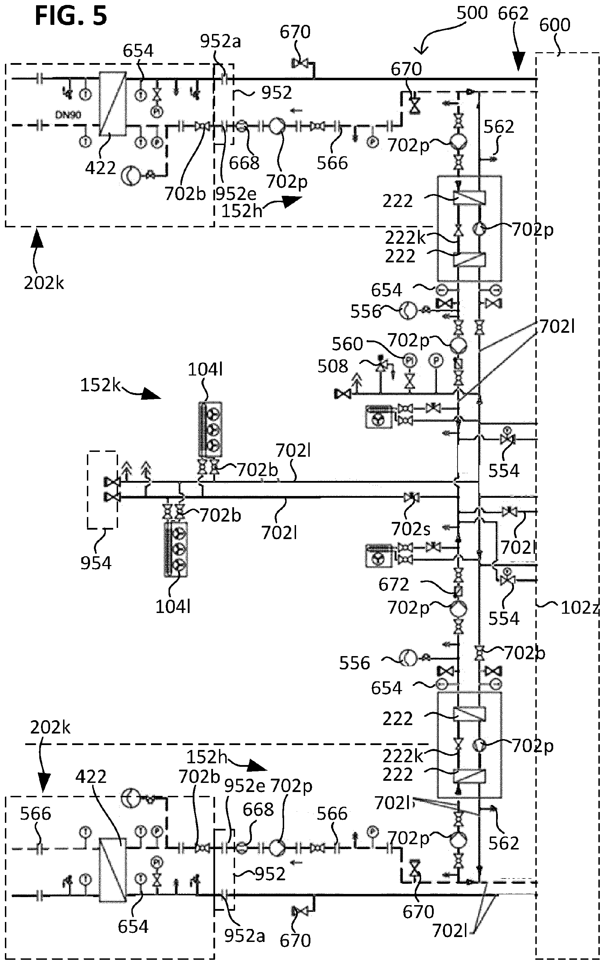

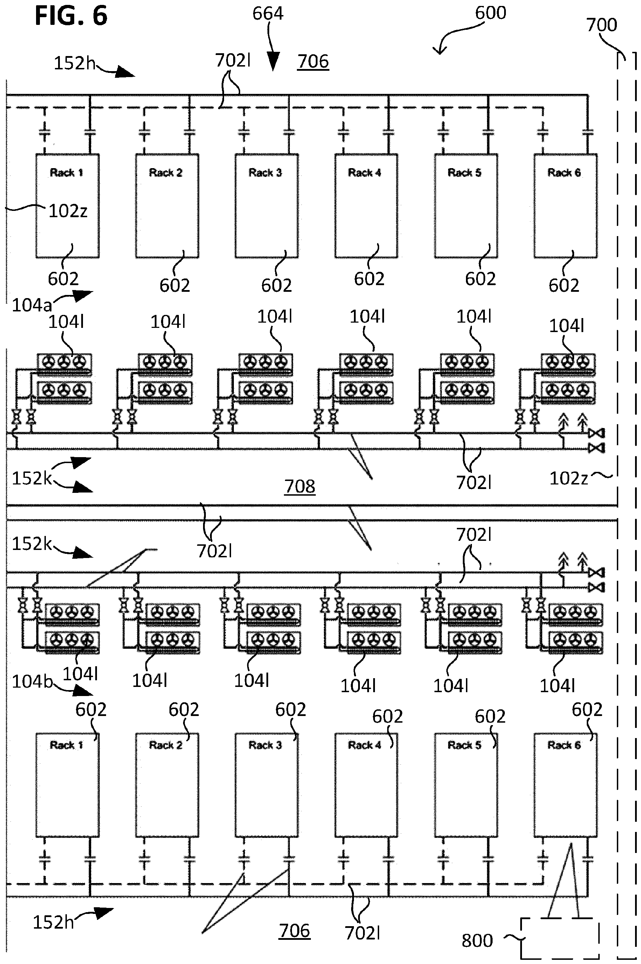

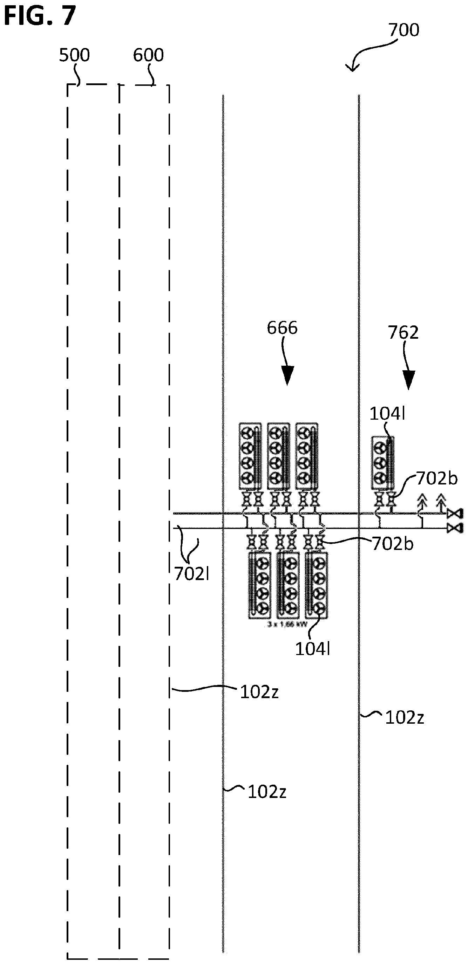

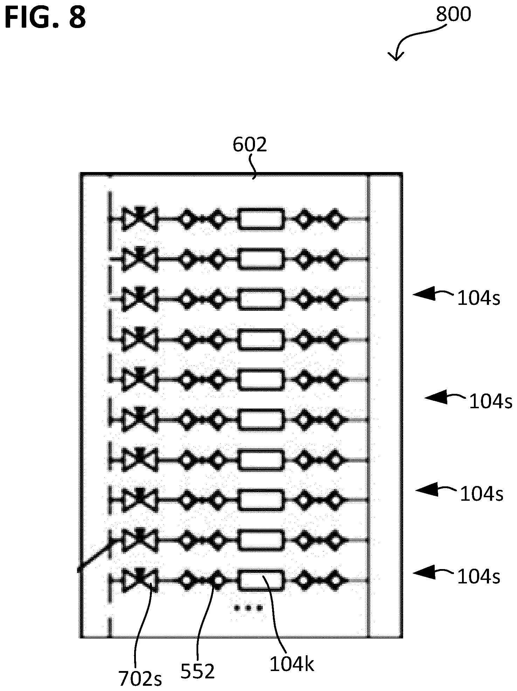

**Fig.5****,** **Fig.6****,** **Fig.7****,** **Fig.8** veranschaulichen jeweils ein RZ 151 (z.B. Container-RZ 151) gemäß verschiedenen Ausführungsformen in verschiedenen detaillierten Aufbaudiagrammen 500 bis 800.

Gemäß verschiedenen Ausführungsformen wird ein kompaktes, geschlossenes, hoch energieeffizientes und möglichst wartungsarmes, ausfallsicheres RZ 151, z.B. ein mobiles Container-RZ 151, ermöglicht. Dazu wird eine Kühlung-Infrastruktur 114 bereitgestellt, die eine Bindung der entstehenden Wärme in der Flüssigkeit und somit die Trennung der Rechentechnik von der Umgebung ermöglicht.

Die thermische und mechanische Trennung der Recheneinheiten 104a, 104b von den Umgebungseinflüssen erlaubt einen äußerst energieeffizienten Betrieb und eine große Flexibilität in der Umsetzbarkeit in verschiedensten Klimazonen und unter diversen Wetterbedingungen. Darüber hinaus ermöglicht der Einsatz der Kühlung-Infrastruktur 114 die energieeffiziente Verwertung der entstandenen Wärme für Industrieprozesse oder eine Gebäudeversorgung durch Fernwärme.

Das RZ 151, z.B. dessen Heißflüssigkeit-Kühlung, weist einen oder mehr als einen Heißflüssigkeit-Kreislauf 152h auf, von denen jeder Heißflüssigkeit-Kreislauf 152h an die Serverracks 602 der Rechenanlage 104 heranführt. Optional kann ein oder mehr als ein Wärmetauscher 104l entweder auf Gehäuseebene oder auf Rackebene angeordnet sein. Um die Abwärme, die an die Luft abgegeben wird, zu entziehen, kann eine oder mehr als eine Wärmepumpe 222 verwendet werden.

Bestandteile eines Flüssigkeit-Kreislaufs (z.B. des Heißflüssigkeit-Kreislaufs 152h und/oder des Kaltflüssigkeit-Kreislaufs 152k) können sein: mehrere Versorgungsleitungen 702l (z.B. Rohrleitungen), ein oder mehr als ein Ventil 702b (z.B. Ballventil) und/oder eine oder mehr als eine Pumpe 702p. Optional kann der Flüssigkeit-Kreislauf einen oder mehr als einen Bestandteil folgender Bestandteile aufweisen: einen oder mehr als einen Durchflusssensor 702s, eine oder mehr als eine Schnellkupplung 552, ein oder mehr als ein Durchfluss-Stellglied 554, einen oder mehr als einen Ausdehnungsbehälter 556, ein oder mehr als ein Überdruckventil 558, einen oder mehr als einen Drucksensor 560, einen oder mehr als einen Flansch 566, eine oder mehr als eine Entlüftungsöffnung 562, einen oder mehr als einen Temperatursensor 654, einen oder mehr als einen Durchflusssensor 668, ein oder mehr als ein Einfüllventil 670, und/oder ein oder mehr als ein Rückschlagventil 672. Jedes Paar Versorgungsleitungen 702l, dass einen Strömungspfad durch die Wärmepumpe 222 hindurch bereitstellt, kann einen Versorgungspfad bereitstellen.

Die oder jede Schnellkupplung 552 kann optional ein Ventil (z.B. Rückschlagventil) aufweisen, das beim Entkuppeln der Schnellkupplung durchflussstoppend wirkt.

Mittels einer oder mehr als einer Zwischenwand 102z können mehrere (z.B. räumlich und/oder thermisch) voneinander separierte (z.B. gasseparierte) Bereiche bereitgestellt werden, z.B. ein erster Bereich 662, in welchem die zumindest eine Wärmepumpe 222 angeordnet ist, z.B. ein zweiter Bereich 664, in welchem die Rechenanlage 104 angeordnet ist, z.B. ein dritter Bereich 666, in welchem die UV oder das Netzwerk angeordnet ist, z.B. ein vierter Bereich 762, welcher eine Schleuse bereitstellt. Optional kann in jedem dieser Bereiche ein Wärmetauscher 104l angeordnet sein.

Der oder jeder Wärmetauscher 104l kann beispielsweise Teil eines Sekundärluftsystems sein, welches ferner zumindest einen Ventilator aufweist. Der Ventilator kann eingerichtet sein, Luft aus dem entsprechenden Bereich durch den Wärmetauscher 104l hindurch zu blasen in den Bereich hinein. Von der Umluft zu unterscheiden ist die Sekundärluft, die einem Raum oder Bereich entnommen und nach deren Abkühlung demselben Raum bzw. Bereich wieder zugeführt wird.

Die Flüssigkeitsversorgung der Versorgungsanordnung 202 kann beispielsweise eine oder mehr als eine zusätzliche Wärmepumpe 422 aufweisen.

Optional können anstatt einer einzelnen Wärmepumpe 222 zwei zueinander redundante Wärmepumpen 222 verwendet werden. Alternativ oder zusätzlich können anstatt einer einzelnen Wärmepumpe 222 zwei kaskadierte Wärmepumpen 222 verwendet werden. Beispielsweise können zwei Paare Wärmepumpen 222 zueinander redundant eingerichtet sein, wobei die Wärmepumpen 222 jedes Paars kaskadiert zueinander eingerichtet sind. Bei zwei kaskadierten Wärmepumpen 222 kann die Warmseite der einen Wärmepumpe mit der Kaltseite der anderen Wärmepumpe gekoppelt sein, z.B. mittels eines Fluidkreislaufs 222k. Die so kaskadierten Wärmepumpen 222 können zusammen wie eine größere Wärmepumpe 222 wirken, die einen größeren Temperaturunterschied bereitstellt. Bei zwei redundanten Wärmepumpen 222 können deren Warmseiten miteinander gekoppelt sein und deren Kaltseiten miteinander gekoppelt sein, z.B. jeweils mittels des daran abgekoppelten Flüssigkeit-Kreislaufs 152h, 152k.

Die eine oder mehr als eine Wärmepumpe 222 kann es ermöglichen, dass die Wärme der Luft nicht mit einer herkömmlichen Klimaanlage entzogen werden muss, die beispielsweise einen Abluftschacht nach außen benötigt.

Die oder jede (z.B. zumindest eine) Wärmepumpe 222 kann optional regelbar (auch als modulierbar bezeichnet) sein, d.h. dass deren Pumpleistung gestellt und/oder geregelt werden kann. Beispielsweise kann die Pumpleistung abhängig sein von einem Arbeitspunkt der Wärmepumpe 222, wobei der Arbeitspunkt der Wärmepumpe 222 mittels eines Stellglieds (z.B. einem Leistungsregler) verändert werden kann. Beispielsweise können der modulierbaren Wärmepumpe 222 mehrere Arbeitspunkte bereitgestellt werden, z.B. mindestens drei (z.B. mindestens zehn), oder diese kann kontinuierlich in ihrem Arbeitspunkt verändert werden.

Alternativ (z.B. wenn eine Regelung nicht möglich ist) oder zusätzlich kann eine Warm-Fluidrückspeisung oder ein Kältepufferspeicher mit der Wärmepumpe 222 gekoppelt sein. Alternativ oder zusätzlich kann die Wärmepumpe 222 getaktet betrieben werden, so dass deren Pumpleistung sich als zeitliches Mittel über mehrere Takte ergibt.

Der Kaltflüssigkeit-Kreislauf 152k (auch als Kaltflüssigkeit-Netz oder Kaltflüssigkeit-Verrohrung bezeichnet) kann die Wärme dem zumindest einen Wärmetauscher 104l entziehen. Beispielsweise kann einer oder mehr als einer der Wärmetauscher 104l innerhalb eines Serverracks 602 oder daneben (z.B. darüber) angeordnet sein. Beispielsweise kann einer oder mehr als einer der Gas-Flüssigkeits-Wärmetauscher 104l in einer Wand (z.B. Boden, Decke und/oder Seitenwand) des Raums 102 angeordnet sein. Beispielsweise kann einer oder mehr als einer der Gas-Flüssigkeits-Wärmetauscher 104l als sogenannter Sidecooler (also neben den Racks) oder alternativ oder zusätzlich dazu als sogenannter Frontdoor-Kühler oder sogenannter Backdoor-Kühler eingerichtet sein.

Wird ein oder mehr als ein Gas-Flüssigkeits-Wärmetauscher 104l oberhalb der Racks 602 (z.B. oberhalb jedes Racks 602) angeordnet, ermöglich dies gleichzeitig auch die eine Trennung (anschaulich eine Gasseparation) zwischen Warmgang 706 und Kaltgang 708. Der Kaltgang 708 kann an der Vorderseite der Server angeordnet sein, wobei der Warmgang an der Rückseite der Server angeordnet sein kann.

Weist das RZ 151 genau eine Wärmepumpe 222 oder zwei zueinander redundante Wärmepumpen 222 auf, kann der Kaltflüssigkeit-Kreislauf 152k einen Frischwasserwärmetauscher aufweisen, welcher die Server zusätzlich kühlt. Dann kann der Kaltflüssigkeit-Kreislauf 152k alternativ oder zusätzlich zu der Wärmepumpe 222 mittels des Frischwasserwärmetauschers gekühlt werden, der von außerhalb des Raums 102 mit Frischwasser (beispielsweise eine Temperatur zwischen 5 und 15°C aufweisend) durchströmt wird. Das Frischwasser kann beispielsweise einem Gewässer, einer städtischen Wasserversorgung oder Grundwasser entnommen werden. Zur Systemtrennung kann dann ein Wärmetauscher in den Kaltflüssigkeit-Kreislauf 152k eingebaut werden, der von der Kaltflüssigkeit alternativ oder zusätzlich zu der Wärmepumpe 222 durchströmt wird.

Ausgangsseitig weist das RZ 151 (z.B. dessen Container) im Wesentlichen die folgenden Schnittstellen auf: einen Stromanschluss 916, einen Kaltflüssigkeit-Anschluss 954 (z.B. für Wasser mit einer Temperatur zwischen 4°C und 60°C) und einen Heißflüssigkeit-Anschluss 952 (z.B. für Wasser mit einer Temperatur zwischen 35°C und 95°C) . Der Heißflüssigkeit-Anschluss 952 kann beispielsweise Wasser mit einer Temperatur in einem Bereich von ungefähr 45°C bis ungefähr 55°C aufnehmen und Wasser mit einer Temperatur in einem Bereich von ungefähr 60°C bis ungefähr 70°C oder mehr abgeben.

Die eine oder mehr als eine Wärmepumpe 222 und die Prozessoren der Rechenanlage 104 speisen thermische Energie in den Heißflüssigkeit-Kreislauf 152h ein, so dass ein Wärmefluss von der oder jeder Wärmepumpe 222 und von der Rechenanlage aus dem Raum 102 heraus bereitgestellt wird. Die Einspeisung in die Wärmepumpe 222 kann dabei den Servern 104s vorgeschaltet, den Servern 104s nachgeschaltet oder zu den Servern parallelgeschaltet sein. Gemäß verschiedenen Ausführungsformen kann der Wärmefluss gesteuert und/oder geregelt werden.

Das Regeln kann beispielsweise derart erfolgen, dass die Kühlung der Server 104s und aller weiterer Komponenten des RZ 151 (z.B. innerhalb des Raums 102) hochzuverlässig ist und Regelpriorität hat.

Das Regeln kann beispielsweise derart erfolgen, dass die Raumtemperatur (z.B. Lufttemperatur) auf einen Wert (SollWert) eingestellt wird, der kleiner ist als die maximale Arbeitstemperatur aller verwendeten Komponenten innerhalb des Raums 102. Eine möglichst hohe Raumtemperatur (RT) führt zum energieeffizienten Betrieb der Wärmepumpen 222, d.h. dass ein hoher Effizienzkoeffizient (COP) erreicht wird. Eine möglichst hohe RT minimiert alternativ oder zusätzlich die Leitungswärmeverluste aller Wasserleitungen des Heißflüssigkeit-Kreislaufs 152h. Beispielsweise kann ein Wärmefluss von der Raumluft in kältere Flüssigkeitsleitungen des Heißflüssigkeit-Kreislaufs 152h und/oder des Kaltflüssigkeit-Kreislaufs 152k erfolgen.

Das Regeln ermöglicht es zudem, für Wartungszwecke die Raumtemperatur weiter abzusenken um moderate Arbeitsbedingungen für die Wartung zu schaffen. Beispielsweise kann für eine Wartung eine RT von weniger als 35°C bereitgestellt sein oder werden.

Das RZ 151 kann optional die Schleuse 762 aufweisen, um auch bei Zutritt unabhängiger von den äußeren Einflüssen zu sein, z.B. von Witterungseinflüssen wir z.B. Schneefall und/oder Sandsturm. Ein oder mehr als ein Container-RZ 151 kann beispielsweise innerhalb eines Gebäudes oder auch im Freien aufgestellt werden.

Der Raum 102 (z.B. das Gehäuse 1102g des Containers 102) kann eine geschlossene, thermisch separierende Hülle aufweisen, die beispielsweise einen Dämmstoff aufweisend oder daraus gebildet sein kann (beispielsweise Fasern und/oder einen Schaum aufweisend). Beispielsweise kann das Gehäuse 1102g des Containers 102 (z.B. einen Bioersatzkunststoff, wie z.B. WPC) aufweisen oder daraus gebildet sein. Das Gehäuse 1102g kann beispielsweise vorgefertigt sein, z.B. gemäß einer ISO-Containernorm.

Das Gestell der Rechenanlage 104 muss nicht notwendigerweise Racks oder Serverschränke aufweisen, sondern kann beispielsweise nur eine Rahmenstruktur aufweisen und optional eine Stromverteilung und Wasserverteilung der Rechenanlage 104 halten. Das Innere des Raums 102 kann der Kaltluftversorgung per Wärmetauscher 104l dienen, der mittels des Kaltflüssigkeit-Kreislaufs 152k mit der Kaltseite der Wärmepumpe(n) 222 gekoppelt sein kann und somit als Wärmequelle für die Wärmepumpe(n) 222 wirkt. Somit werden verlustbehaftete elektrische Komponenten ausreichend gekühlt und die entstandene Wärme im Kühlmedium des Kaltflüssigkeit-Kreislaufs 152k gebunden. Dies ermöglicht eine im Anschluss sehr effiziente Wärmeabfuhr, z.B. eine Wärme-Weiterverwendung in industriellen Prozessen oder der Beheizung von Gebäuden durch Fernwärme.

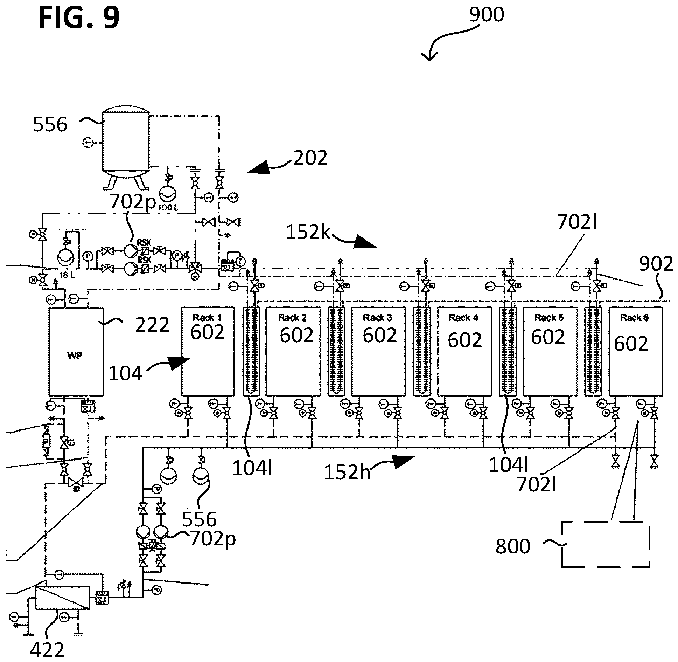

**Fig.9** veranschaulicht ein RZ 151 gemäß verschiedenen Ausführungsformen in einem schematischen Aufbaudiagramm 900. Das RZ 151 kann in Aufbaudiagramm 900 genau eine Wärmepumpe 222 aufweisen. Die Wärmetauscher 104l können Teil passiver Wärmesenken sein.

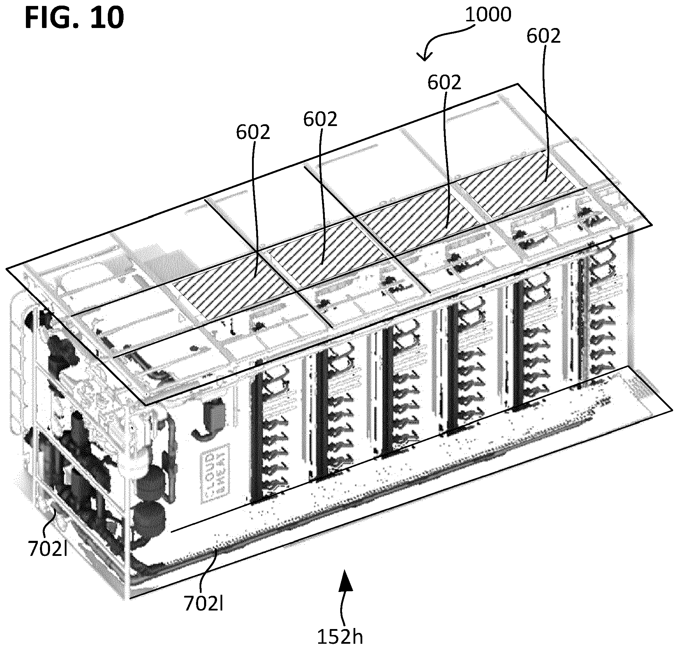

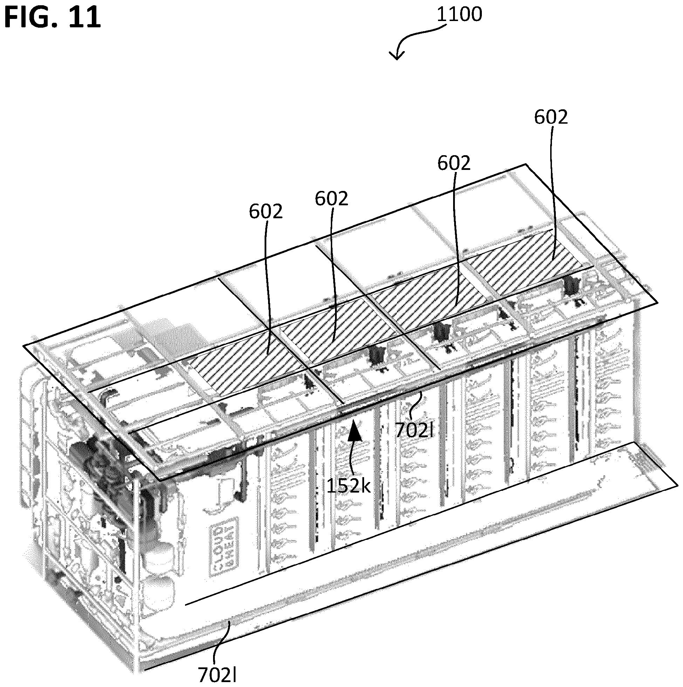

**Fig.10** und **Fig.11** veranschaulichen jeweils ein Container-RZ 151 gemäß verschiedenen Ausführungsformen in einem schematischen Perspektivansicht 1000, 1100, wobei jeweils Komponenten des Heißflüssigkeit-Kreislaufs 152h und des Kaltflüssigkeit-Kreislaufs 152k hervorgehoben sind.

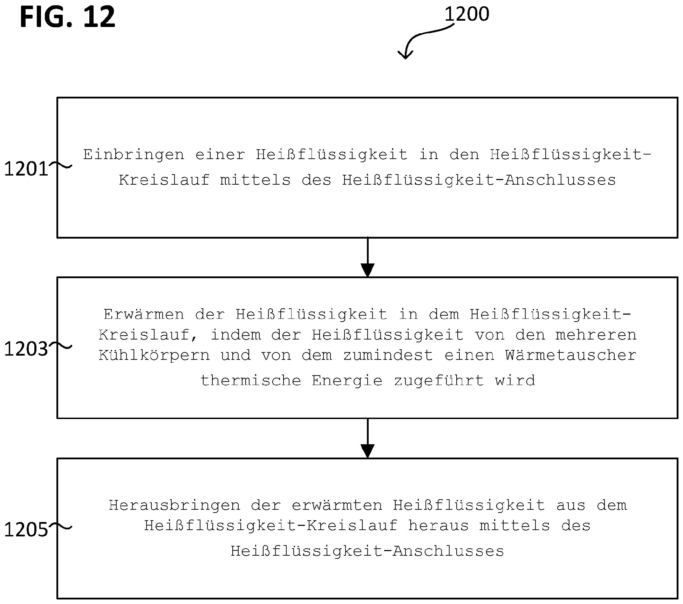

**Fig.12** veranschaulicht ein Verfahren 1200 gemäß verschiedenen Ausführungsformen in einem schematischen Ablaufdiagramm.

Das Verfahren 1200 kann aufweisen: in 1201, Einbringen einer Heißflüssigkeit in den Heißflüssigkeit-Kreislauf mittels des Heißflüssigkeit-Anschlusses; in 1203, Erwärmen der Heißflüssigkeit in dem Heißflüssigkeit-Kreislauf, indem der Heißflüssigkeit von den mehreren Kühlkörpern und von dem zumindest einen Wärmetauscher thermische Energie zugeführt wird; in 1205, Herausbringen der erwärmten Heißflüssigkeit aus dem Heißflüssigkeit-Kreislauf heraus mittels des Heißflüssigkeit-Anschlusses.

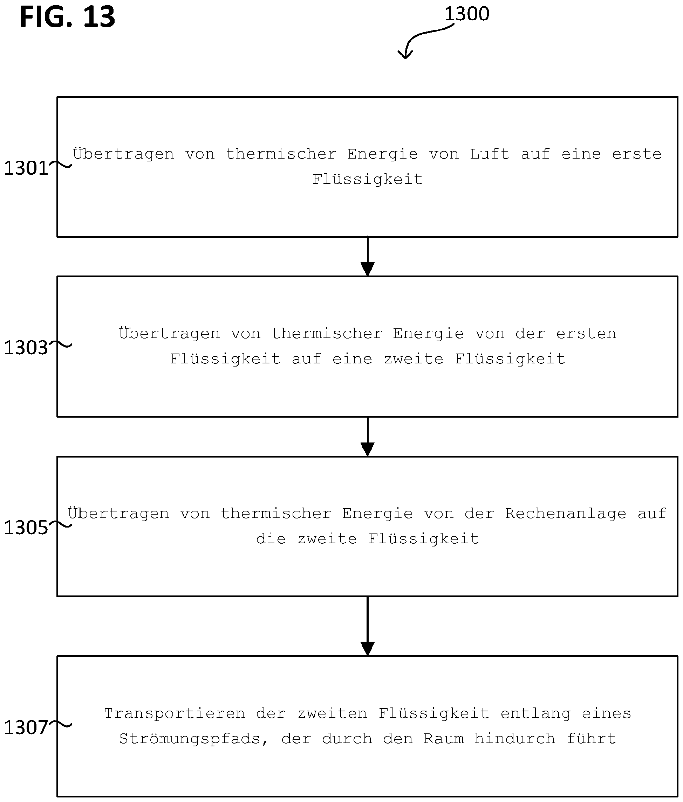

**Fig.13** veranschaulicht ein Verfahren 1300 gemäß verschiedenen Ausführungsformen in einem schematischen Ablaufdiagramm.

Das Verfahren 1200 kann aufweisen: in 1301, erstes Übertragen thermischer Energie von Luft auf eine erste Flüssigkeit (auch als Kaltflüssigkeit bezeichnet), wobei die Luft in einem Raum angeordnet ist, in welchem ferner eine Rechenanlage angeordnet ist (und beispielsweise eine Wärmepumpe angeordnet ist), wobei die Rechenanlage und/oder die Wärmepumpe beispielsweise in Kontakt mit der Luft sind; in 1303, zweites Übertragen thermischer Energie von der ersten Flüssigkeit auf eine zweite Flüssigkeit (auch als Heißflüssigkeit bezeichnet), die eine größere Temperatur aufweist als die erste Flüssigkeit, beispielsweise mittels der Wärmepumpe; in 1305, drittes Übertragen thermischer Energie von der Rechenanlage (z.B. deren Prozessoren) auf die zweite Flüssigkeit; und in 1307, Transportieren der zweiten Flüssigkeit entlang eines Strömungspfads, der durch den Raum hindurch führt.

Das Transportieren kann aufweisen: Herausbringen der zweiten Flüssigkeit aus dem den Raum heraus und wieder hereinbringen der zweiten Flüssigkeit in den Raum hinein entlang des Strömungspfads. Der Strömungspfad kann beispielsweise in sich geschlossenen sein. Die Kaltflüssigkeit kann beispielsweise (z.B. nur) entlang eines zusätzlichen Strömungspfads geführt werden, welcher innerhalb des Raumes angeordnet ist.

Das erste Übertragen, das zweite Übertragen und/oder das dritte Übertragen können beispielsweise innerhalb des Raums 102 erfolgen.

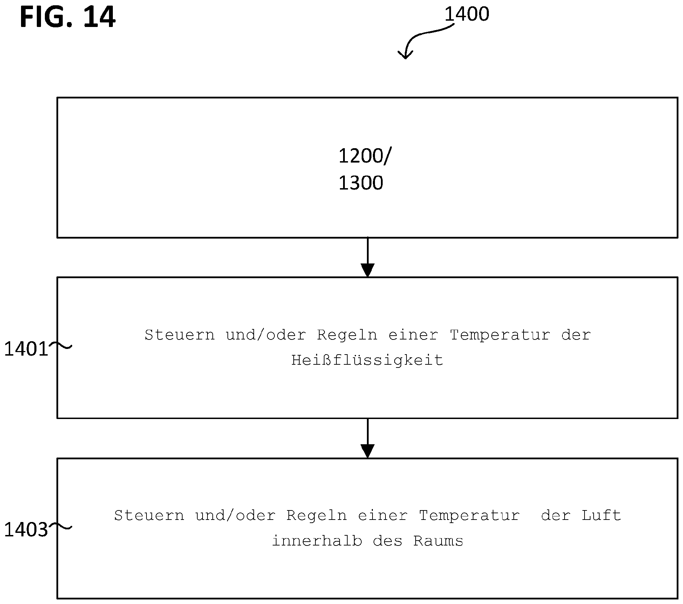

**Fig.14** veranschaulicht ein Verfahren 1400 gemäß verschiedenen Ausführungsformen in einem schematischen Ablaufdiagramm, welches beispielsweise das Verfahren 1200 und/oder das Verfahren 1300 aufweist.

Das Verfahren 1400 kann in 1401 aufweisen: Steuern und/oder Regeln einer Temperatur (auch als Heißtemperatur bezeichnet) der Heißflüssigkeit, z.B. gemäß einer Vorgabe. Das Steuern und/oder Regeln der Heißtemperatur kann aufweisen: Vergrößern des Durchflusses an Heißflüssigkeit durch zumindest eine Wärmepumpe hindurch, wenn die Heißtemperatur die Vorgabe erfüllt (z.B. gleich oder größer einer Soll-Temperatur ist); und/oder Verkleinern des Durchflusses an Heißflüssigkeit durch die zumindest eine Wärmepumpe hindurch, wenn die Heißtemperatur die Vorgabe nicht erfüllt.

Alternativ oder zusätzlich kann das Verfahren 1400 in 1403 aufweisen: Steuern und/oder Regeln einer Temperatur (auch als Raumtemperatur bezeichnet) der Luft innerhalb des Raums. Das Steuern und/oder Regeln der Raumtemperatur kann aufweisen: Vergrößern einer elektrischen Leistungsaufnahme zumindest einer Wärmepumpe, wenn die Raumtemperatur die Vorgabe erfüllt (z.B. gleich oder größer einer Soll-Temperatur ist); und/oder Verkleinern der elektrischen Leistungsaufnahme, wenn die Raumtemperatur die Vorgabe nicht erfüllt. Die elektrische Leistungsaufnahme kann beispielsweise mittels eines Stellglieds der Wärmepumpe verändert werden. Das Stellglied kann beispielsweise einen oder mehr als einen Arbeitsparameter der Wärmepumpe stellen, welcher den Arbeitspunkt der Wärmepumpe definiert. Der Arbeitsparameter kann beispielsweise eine Pumpleistung der Wärmepumpe sein. Die zumindest eine Wärmepumpe kann die Heißflüssigkeit mit der Kaltflüssigkeit thermisch koppeln.

Alternativ oder zusätzlich kann das Steuern und/oder Regeln der Raumtemperatur aufweisen: Ansteuern des Kaltflüssigkeit-Kreislauf 152k gemäß einer Soll-Temperatur (z.B. von Luft innerhalb des Raums 102); Umschalten der Soll-Temperatur gemäß einem Wartungsbetrieb und einem Normalbetrieb, wobei die Soll-Temperatur gemäß dem Wartungsbetrieb kleiner als 35°C ist und die Soll-Temperatur gemäß dem Normalbetrieb größer ist als ungefähr 35°C (z.B. als 40°C oder als 45°C oder als 50°C oder als 55°C). Die Ist-Temperatur kann beispielsweise mittels eines oder mehr als eines Temperatursensors erfasst werden. Das Umschalten kann beispielsweise gemäß einer Eingabe an einer Benutzerschnittstelle, per Fernzugriff und/oder in Reaktion darauf, dass eine Person innerhalb des Raums 102 erfasst wird, erfolgen.

## Patentansprüche

1. Rechenzentrum (151), aufweisend:
• eine in einem Raum (102) angeordnete Rechenanlage (104), wobei die Rechenanlage (104) mehrere Kühlkörper (104k) und mehrere Prozessoren aufweist, von denen jeder Prozessor mit einem Kühlkörper (104k) der mehreren Kühlkörper (104k) thermisch gekoppelt ist;
• zumindest eine in dem Raum (102) angeordnete Wärmepumpe (222);
• zumindest einen in dem Raum (102) angeordneten Gas-Flüssigkeit-Wärmetauscher (104l);
• einen Heißflüssigkeit-Kreislauf (152h), welcher die mehreren Kühlkörper (104k) mit der Wärmepumpe (222) koppelt, wobei der Heißflüssigkeit-Kreislauf (152h) ferner an einer Wand des Raums (102) einen Heißflüssigkeit-Anschluss (952) aufweist, wobei der Heißflüssigkeit-Kreislauf (152h) thermische Energie durch den Heißflüssigkeit-Anschluss (952) aus dem Raum heraus bereitstellt; und
• einen Kaltflüssigkeit-Kreislauf (152k), welcher die Wärmepumpe (222) mit dem Gas-Flüssigkeit-Wärmetauscher (104l) koppelt;
• wobei die Wärmepumpe (222) eingerichtet ist, dem Kaltflüssigkeit-Kreislauf (152k) thermische Energie zu entziehen und diese dem Heißflüssigkeit-Kreislauf (152h) zuzuführen.

2. Rechenzentrum (151) gemäß Anspruch 1, wobei der Raum (102) als ein Container eingerichtet ist.

3. Rechenzentrum (151) gemäß Anspruch 2, wobei der Container als ein Container gemäß ISO Norm 668 eingerichtet ist.

4. Rechenzentrum (151) gemäß einem der Ansprüche 1 bis 3, ferner aufweisend:
eine Heißflüssigkeitsversorgung (202k) außerhalb des Raums (102), wobei die Heißflüssigkeitversorgung (202) mit dem Heißflüssigkeit-Anschluss (952) gekoppelt ist.

5. Rechenzentrum (151) gemäß Anspruch 4,
wobei mittels der Heißflüssigkeitsversorgung (202k) ein in sich geschlossener Strömungspfad (155) durch den Heißflüssigkeit-Kreislauf (152h) hindurch bereitgestellt ist.

6. Rechenzentrum (151) gemäß einem der Ansprüche 1 bis 5, wobei eine Wärmepumpe (222) der zumindest einen Wärmepumpe (222) mit einem modulierbaren Arbeitspunkt eingerichtet ist.

7. Rechenzentrum (151) gemäß einem der Ansprüche 1 bis 6, ferner aufweisend:
eine Energieversorgung-Infrastruktur (106) innerhalb des Raums (102) zum Versorgen der Rechenanlage (104) mit elektrischer Energie, wobei der Gas-Flüssigkeit-Wärmetauscher (104l) eingerichtet ist, wobei die Energieversorgung-Infrastruktur des Raums (102) hinsichtlich einer Ausfallsicherheit der Rechenanlage (104) vorzertifiziert ist.

8. Rechenzentrum (151) gemäß einem der Ansprüche 1 bis 7, wobei eine Kühl-Infrastruktur (114), welche die Wärmepumpe (222), den Gas-Flüssigkeit-Wärmetauscher (104l), den Heißflüssigkeit-Kreislauf (152h) und den Kaltflüssigkeit-Kreislauf (152k) aufweist, hinsichtlich einer Ausfallsicherheit der Rechenanlage (104) vorzertifiziert ist.

9. Rechenzentrum (151) gemäß einem der Ansprüche 1 bis 8, ferner aufweisend:
• einen Ausfallschalter,
• wobei die zumindest eine Wärmepumpe (222) ein Paar zueinander redundant eingerichtete Wärmepumpen (222) aufweist;
• wobei der Ausfallschalter eingerichtet ist, in Reaktion auf einen Ausfall einer Wärmepumpe (222) des Paars auf die andere Wärmepumpe (222) des Paars umzuschalten.

10. Rechenzentrum (151) gemäß einem der Ansprüche 1 bis 9, wobei der Raum (102) derart eingerichtet ist, dass ein Luftzirkulationsbereich (102i) des Raums (102), an den die Rechenanlage (104) und/oder der Wärmetauscher (104l) angrenzen, gegenüber einem Äußeren des Raums (102) hermetisch abgedichtet ist.

11. Rechenzentrum (151) gemäß einem der Ansprüche 1 bis 10, wobei der Heißflüssigkeit-Kreislauf (152h) derart eingerichtet ist, dass im Betrieb eine Heißflüssigkeit-Temperatur des Heißflüssigkeit-Kreislaufes (152h) größer ist als eine Kaltflüssigkeit-Temperatur des Kaltflüssigkeit-Kreislaufes (152k).

12. Rechenzentrum (151) gemäß Anspruch 11, ferner aufweisend:
eine Steuervorrichtung, welche eingerichtet ist, einen Durchfluss des Heißflüssigkeit-Kreislaufs (152h) gemäß der Heißflüssigkeit-Temperatur und/oder die zumindest eine Wärmepumpe (222) gemäß der Kaltflüssigkeit-Temperatur anzusteuern.

13. Rechenzentrum (151) gemäß Anspruch 12, wobei die Steuervorrichtung eingerichtet ist, die Kaltflüssigkeit-Temperatur zwischen zumindest zwei Temperaturen umzuschalten.

14. Rechenzentrum (151) gemäß Anspruch 13, wobei die Steuervorrichtung eingerichtet ist, die Kaltflüssigkeit-Temperatur gemäß einem Betriebszustand des Rechenzentrums (151) umzuschalten.

15. Verfahren (1300) zur Kühlung eines Rechenzentrums gemäß einem der Ansprüche 1 bis 14, das Verfahren aufweisend:
• Übertragen (1301) thermischer Energie von Luft auf eine erste Flüssigkeit, wobei die Luft in einem Raum (102) angeordnet ist, in welchem ferner eine Rechenanlage (104) angeordnet ist;
• Übertragen (1303) thermischer Energie von der ersten Flüssigkeit auf eine zweite Flüssigkeit, die eine größere Temperatur aufweist als die erste Flüssigkeit;
• Übertragen (1303) thermischer Energie von der Rechenanlage (104) auf die zweite Flüssigkeit;
• Transportieren (1307) der zweiten Flüssigkeit entlang eines Strömungspfads, der durch den Raum (102) hindurchführt, wobei thermische Energie durch den Heißflüssigkeit-Anschluss (952) aus dem Raum (102) heraus bereitgestellt wird.

## Claims

1. Data processing center (151), comprising:
• a computing system (104) arranged in a room (102), the computing system (104) having a plurality of heat sinks (104k) and a plurality of processors, each processor being thermally coupled to a heat sink (104k) of the plurality of heat sinks (104k);
• at least one heat pump (222) arranged in the room;
• at least one gas-liquid heat exchanger (1041) arranged in the room (102);
• a hot liquid loop (152h) coupling the plurality of heat sinks (104k) to the heat pump (222), the hot liquid loop (152h) further comprising a hot liquid port at a wall of the room (102), the hot liquid loop (152h) providing thermal energy out of the room through the hot liquid port; and
• a cold liquid loop (152k), which couples the heat pump (222) with the gas-liquid heat exchanger (1041);
• wherein the heat pump (222) is configured to extract thermal energy from the cold liquid loop (152k) and supply it to the hot liquid loop (152h).

2. The data processing center (151) according to claim 1, wherein the room (102) is arranged as a container.

3. The data processing center (151) according to claim 2, whereby the container is set up as a container according to ISO standard 668.

4. The data processing center (151) according to any one of claims 1 to 3, further comprising:
a hot liquid supply (202k) outside the room (102), the hot liquid supply (202) being coupled to the hot liquid port (952).

5. The data processing center (151) according to claim 4, wherein a closed flow path (155) is provided through the hot liquid loop (152h) by means of the hot liquid supply (202k).

6. The data processing center (151) according to any one of claims 1 to 5, wherein a heat pump (222) of the at least one heat pump (222) is configured with a modulatable operating point.

7. The data processing center (151) according to any one of claims 1 to 6, further comprising:
a power supply infrastructure (106) within the room (102) for supplying the computing system (104) with electrical energy, wherein the gas-liquid heat exchanger (1041) is arranged, wherein the power supply infrastructure of the room (102) is pre-certified with respect to a fail-safety of the computing system (104).

8. The data processing center (151) according to any one of claims 1 to 7, wherein a cooling infrastructure (114) comprising the heat pump (222), the gas-liquid heat exchanger (1041), the hot liquid loop (152h) and the cold liquid loop (152k) is pre-certified with respect to a fail-safety of the computing system (104).

9. The data processing center (151) according to any one of claims 1 to 8, further comprising:
• a failure switch,
• wherein the at least one heat pump (222) comprises a pair of heat pumps (222) that are configured redundantly to one another;
• wherein the failure switch is configured, in response to a failure of one heat pump (222) of the pair, to switch to the other heat pump (222) of the pair.

10. The data processing center (151) according to any one of claims 1 to 9, wherein the room (102) is configured such that an air circulation region (102i) of the room (102), which is adjacent to the computing device (104) and/or the heat exchanger (1041), is hermetically sealed with respect to an exterior of the room (102).

11. The data processing center (151) according to any one of claims 1 to 10, wherein the hot liquid circuit (152h) is arranged such that, in operation, a hot liquid temperature of the hot liquid circuit (152h) is higher than a cold liquid temperature of the cold liquid circuit (152k).

12. The data processing center (151) according to claim 11, further comprising:
a control device configured to control a flow of the hot liquid loop (152h) according to the hot liquid temperature and/or the at least one heat pump (222) according to the cold liquid temperature.

13. The data processing center (151) according to claim 12, wherein the control device is configured to switch the cold fluid temperature between at least two temperatures.

14. The data processing center (151) according to claim 13, wherein the control device is configured to switch the cold liquid temperature according to an operating state of the data processing center (151).

15. A method (1300) for cooling a data processing center according to any one of claims 1 to 14, the method comprising:
• transferring (1301) thermal energy from air to a first liquid, the air being disposed in a room (102) in which further a computing system (104) is arranged;
• transferring (1303) thermal energy from the first liquid to a second liquid that has a higher temperature than the first liquid;
• transferring (1303) thermal energy from the computing system (104) to the second liquid;
• transporting (1307) the second liquid along a flow path passing through the room (102), wherein thermal energy is provided by the hot liquid port (952) out of the room (102).

## Revendications

1. Centre de calcul (151), comprenant :
• une installation de calcul (104) disposée dans un espace (102), l'installation de calcul (104) comprenant plusieurs dissipateurs thermiques (104k) et plusieurs processeurs, dont chaque processeur est couplé thermiquement à un dissipateur thermique (104k) des plusieurs dissipateurs thermiques (104k) ;
• au moins une pompe à chaleur (222) disposée dans l'espace (102) ;
• au moins un échangeur de chaleur gaz-liquide (1041) disposé dans l'espace (102) ;
• un circuit de liquide chaud (152h) couplant les plusieurs dissipateurs thermiques (104k) à la pompe à chaleur (222), le circuit de liquide chaud (152h) comprenant en outre un connecteur de liquide chaud (952) sur une paroi de l'espace (102), le circuit de liquide chaud (152h) fournissant de l'énergie thermique hors de l'espace à travers le connecteur de liquide chaud (952) ; et
• un circuit de liquide froid (152k) couplant la pompe à chaleur (222) à l'échangeur de chaleur gaz-liquide (1041) ;
• dans lequel la pompe à chaleur (222) est configurée pour extraire de l'énergie thermique du circuit de liquide froid (152k) et la fournir au circuit de liquide chaud (152h).

2. Centre de calcul (151) selon la revendication 1,
dans lequel l'espace (102) est configuré comme un conteneur.

3. Centre de calcul (151) selon la revendication 2,
dans lequel le conteneur est configuré comme un conteneur selon la norme ISO 668.

4. Centre de calcul (151) selon l'une des revendications 1 à 3, comprenant en outre :
une alimentation en liquide chaud (202k) extérieure à l'espace (102), l'alimentation en liquide chaud (202) étant couplée au connecteur de liquide chaud (952).

5. Centre de calcul (151) selon la revendication 4,
dans lequel un chemin d'écoulement (155) fermé en soi est fourni à travers le circuit de liquide chaud (152h) au moyen de l'alimentation en liquide chaud (202k).

6. Centre de calcul (151) selon l'une des revendications 1 à 5, dans lequel une pompe à chaleur (222) de ladite au moins une pompe à chaleur (222) est configurée avec un point de fonctionnement modulable.

7. Centre de calcul (151) selon l'une des revendications 1 à 6, comprenant en outre :
une infrastructure d'alimentation en énergie (106) à l'intérieur de l'espace (102) pour fournir de l'énergie électrique à l'installation de calcul (104), l'échangeur de chaleur gaz-liquide (1041) étant agencé, l'infrastructure d'alimentation en énergie de l'espace (102) étant pré-certifiée en ce qui concerne une résilience de l'installation de calcul (104).

8. Centre de calcul (151) selon l'une des revendications 1 à 7, dans lequel une infrastructure de refroidissement (114) comprenant la pompe à chaleur (222), l'échangeur de chaleur gaz-liquide (1041), le circuit de liquide chaud (152h) et le circuit de liquide froid (152k) est pré-certifiée en ce qui concerne une résilience de l'installation de calcul (104).

9. Centre de calcul (151) selon l'une des revendications 1 à 8, comprenant en outre :
• un commutateur de panne,
• dans lequel ladite au moins une pompe à chaleur (222) comprend une paire de pompes à chaleur (222) configurées de manière redondante l'une par rapport à l'autre ;
• dans lequel le commutateur de panne est configuré pour commuter sur l'autre pompe à chaleur (222) de la paire en réponse à une panne d'une pompe à chaleur (222) de la paire.

10. Centre de calcul (151) selon l'une des revendications 1 à 9, dans lequel l'espace (102) est configuré de manière à ce qu'une zone de circulation d'air (102i) de l'espace (102), à laquelle sont adjacents l'installation de calcul (104) et/ou l'échangeur de chaleur (1041), soit hermétiquement fermée par rapport à un extérieur de l'espace (102).

11. Centre de calcul (151) selon l'une des revendications 1 à 10, dans lequel le circuit de liquide chaud (152h) est configuré de telle sorte que, en fonctionnement, une température de liquide chaud du circuit de liquide chaud (152h) est supérieure à une température de liquide froid du circuit de liquide froid (152k).

12. Centre de calcul (151) selon la revendication 11, comprenant en outre :
un dispositif de commande configuré pour commander un débit du circuit de liquide chaud (152h) en fonction de la température de liquide chaud et/ou pour commander ladite au moins une pompe à chaleur (222) en fonction de la température de liquide froid.

13. Centre de calcul (151) selon la revendication 12, dans lequel le dispositif de commande est configuré pour commuter la température de liquide froid entre au moins deux températures.

14. Centre de calcul (151) selon la revendication 13, dans lequel le dispositif de commande est configuré pour commuter la température de liquide froid en fonction d'un état de fonctionnement du centre de calcul (151).

15. Procédé (1300) de refroidissement d'un centre de calcul selon l'une des revendications 1 à 14, le procédé comprenant :
• le transfert (1301) d'énergie thermique de l'air à un premier liquide, l'air étant disposé dans un espace (102) dans lequel est en outre disposée une installation de calcul (104) ;
• le transfert (1303) d'énergie thermique du premier liquide à un deuxième liquide ayant une température supérieure à celle du premier liquide ;
• le transfert (1303) d'énergie thermique de l'installation de calcul (104) au deuxième liquide ;
• le transport (1307) du deuxième liquide le long d'un chemin d'écoulement traversant l'espace (102), l'énergie thermique étant fournie par le connecteur de liquide chaud (952) hors de l'espace (102).
